# EUROPEAN PATENT APPLICATION

(11) **EP 4 668 719 A1**
(43) Date of publication of application: **24.12.2025**
(21) Application number: 23949612.8
(22) Date of filing: 18.12.2023
(51) Int. Cl.: H04M 1/02, F16C 11/04

(54) **PANEL ASSEMBLY AND MANUFACTURING METHOD THEREFOR, ROTATING SHAFT MECHANISM, AND ELECTRONIC DEVICE**

(30) Priority: 23.08.2023 CN 202311061216
(71) Applicant: Honor Device Co., Ltd., Shenzhen, Guangdong 518040 (CN)
(72) Inventor: DAN, Jinqi, Shenzhen, Guangdong 518040 (CN); XIONG, Lizhi, Shenzhen, Guangdong 518040 (CN); DONG, Shaohong, Shenzhen, Guangdong 518040 (CN); CHEN, Ruihao, Shenzhen, Guangdong 518040 (CN)
(74) Representative: Thun, Clemens
(86) International application number: PCT/CN2023/139424
(87) International publication number: WO 2025/039434

(57) **Abstract**

This application discloses a door panel assembly, a manufacturing method therefor, a rotary shaft mechanism, and an electronic device, and is applied to the field of terminal device technologies. The door panel assembly includes a door panel, including a first surface. A length direction of the door panel is a first direction. M limiting structures are spaced apart from each other on the first surface and/or inside the door panel in the first direction. M+N kinematic pair sliding grooves are spaced apart from each other on the first surface, positions of the M kinematic pair sliding grooves are opposite to positions of the M limiting structures, the M kinematic pair sliding grooves are fastened to the corresponding limiting structures, the N kinematic pair sliding grooves are integrally formed with the door panel, M is a positive integer, and N is a positive integer. In this way, not only strength of the door panel and each kinematic pair sliding groove can be improved, but also position precision of each kinematic pair sliding groove can be improved. The limiting structure is located on the first surface and/or inside the door panel, and does not occupy thickness space of the door panel, and therefore does not affect thickness space of the rotary shaft mechanism, to implement lightening and thinning of the electronic device.

## Description

This application claims priority to Chinese Patent Application No. 202311061216.4, entitled "DOOR PANEL ASSEMBLY, MANUFACTURING METHOD THEREFOR, ROTARY SHAFT MECHANISM, AND ELECTRONIC DEVICE" and filed on August 23, 2023, which is incorporated herein by reference in its entirety.

### TECHNICAL FIELD

This application relates to the field of terminal device technologies, and in particular, to a door panel assembly, a manufacturing method therefor, a rotary shaft mechanism, and an electronic device.

### BACKGROUND

With development of a terminal technology, a display screen size of an electronic device such as a mobile phone is increasingly large. A foldable-screen device gradually enters a use scenario of a user, to consider a portable requirement of the user while increasing the display screen size.

The foldable-screen device includes a rotary shaft mechanism and a flexible screen. The rotary shaft mechanism includes a base and a left door panel and a right door panel that are located on two sides of the base. The flexible screen covers the left door panel and the right door panel (collectively referred to as a door panel assembly below). The door panel assembly includes a kinematic pair, configured to implement connection between the door panel assembly and another structural member. The door panel assembly may be folded or unfolded with the rotary shaft mechanism, to support the flexible screen in an unfolded state, and press the flexible screen into a water drop form in a folded state.

A molding manner of a main body of the door panel assembly and the kinematic pair may be usually an all-in-one injection molding manner or a carbon fiber and embedded injection molding manner. However, in this molding manner, strength of the overall door panel assembly and the kinematic pair tends to be weak, and thickness space is occupied. A molding manner of the main body of the door panel assembly and the kinematic pair may be usually a manner of performing connection through riveting. However, in this molding manner, a large quantity of parts are required, position precision of the kinematic pair is not easily ensured, and thickness space is also occupied. It can be learned that an existing door panel assembly cannot meet a use requirement.

### SUMMARY

This application provides a door panel assembly, a manufacturing method therefor, a rotary shaft mechanism, and an electronic device, to resolve a problem that an existing door panel assembly cannot meet a use requirement.

According to a first aspect, this application provides a door panel assembly, including: a door panel, including a first surface, where a length direction of the door panel is a first direction; M limiting structures, where the M limiting structures are spaced apart from each other on the first surface and/or inside the door panel in the first direction; and M+N kinematic pair sliding grooves, where the M+N kinematic pair sliding grooves are spaced apart from each other on the first surface in the first direction, positions of the M kinematic pair sliding grooves are opposite to positions of the M limiting structures, the M kinematic pair sliding grooves are fastened to the corresponding limiting structures, the N kinematic pair sliding grooves are integrally formed with the door panel, M is a positive integer, and N is a positive integer.

According to the door panel assembly provided in this embodiment of this application, the M kinematic pair sliding grooves are fastened by using the M limiting structures on the door panel, and the N kinematic pair sliding grooves are integrally formed with the door panel, to not only improve strength of the door panel and each kinematic pair sliding groove, but also improve position precision of each kinematic pair sliding groove. The limiting structure is located on the first surface and/or inside the door panel, and does not occupy thickness space of the door panel, and therefore does not affect thickness space of a rotary shaft mechanism, to implement lightening and thinning of the electronic device and meet a use requirement.

In some implementations, the M+N kinematic pair sliding grooves include N higher pair sliding grooves and M lower pair sliding grooves; and the N higher pair sliding grooves and the M lower pair sliding grooves are spaced apart from each other on the first surface in the first direction. In this way, different higher pair sliding grooves and different lower pair sliding grooves may be used to implement connection to different structural members in the rotary shaft mechanism.

In some implementations, the limiting structure includes a first limiting structure; M first limiting structures are spaced apart from each other on the first surface and/or inside the door panel in the first direction; and positions of the M first limiting structures are opposite to positions of the M lower pair sliding grooves, and the M lower pair sliding grooves are formed on the corresponding first limiting structures through injection molding. In this way, the lower pair sliding groove may be injection-molded on the corresponding first limiting structure, to improve binding strength between the lower pair sliding groove and the first limiting structure, thereby improving strength of the lower pair sliding groove and the door panel.

In some implementations, the first limiting structure is located on the first surface; and the first limiting structure includes a base and a first fastening groove, the first fastening groove is close to the base in a direction perpendicular to the first direction, the base includes at least one through hole, and an axis direction of the through hole is the same as the first direction. The base includes at least two substrates forming a stepped structure in the first direction; and the substrate includes the through hole. In this way, plastic may be distributed in a through hole and two stepped substrates in a bonding manner, to improve a binding force between the lower pair sliding groove and the first limiting structure. In this way, not only the lower pair sliding groove can be accurately positioned, to stably fasten the lower pair sliding groove, but also strength of the lower pair sliding groove can be improved.

In some implementations, the lower pair sliding groove includes a first lower pair bonding structure, a first fastening base, and a first sliding groove base; the first lower pair bonding structure is formed on the base and in the at least one through hole through injection molding, and the first lower pair bonding structure includes at least one fastening post formed in the at least one through hole; the first sliding groove base is formed on a top of a side surface of the first lower pair bonding structure through injection molding, and is injection-molded by a first width in the first direction; and the first fastening base is formed in the first fastening groove through injection molding, and is connected to the first lower pair bonding structure and the first sliding groove base. In this way, the lower pair sliding groove is embedded into the inside of the door panel by using the first fastening base, and the first lower pair bonding structure and the base are bound, to improve a binding force between the lower pair sliding groove and the first limiting structure. In this way, not only stability of the lower pair sliding groove and the door panel can be improved, to improve strength of the door panel and the lower pair sliding groove, but also improve position precision of the lower pair sliding groove.

In some implementations, the first limiting structure is located inside the door panel; and the first limiting structure includes a recessed hole and a second fastening groove, and the second fastening groove is close to the recessed hole in a direction perpendicular to the first direction. In this way, plastic is distributed in the recessed hole and the second fastening groove, to improve a binding force between the lower pair sliding groove and the first limiting structure. In this way, not only the lower pair sliding groove can be accurately positioned, to stably fasten the lower pair sliding groove, but also strength of the lower pair sliding groove can be improved.

In some implementations, the lower pair sliding groove includes a second lower pair bonding structure, a second fastening base, and a second sliding groove base; the second lower pair bonding structure is formed in the recessed hole through injection molding; the second fastening base is formed in the second fastening groove through injection molding; the second sliding groove base is connected to the second lower pair bonding structure and the second fastening base, and is injection-molded by a first height along the first surface in a second direction; and the second direction is a thickness direction of the door panel. In this way, the lower pair sliding groove is embedded into the inside of the door panel by using the second lower pair bonding structure and the second fastening base, to improve a binding force between the lower pair sliding groove and the first limiting structure. In this way, not only stability of the lower pair sliding groove and the door panel can be improved, to improve strength of the door panel and the lower pair sliding groove, but also improve position precision of the lower pair sliding groove.

In some implementations, the recessed hole includes a first groove and a second groove, the first groove is recessed by a first depth from the first surface to an inside of the door panel, the second groove is recessed by a second depth from a second surface of the door panel to the inside, and the first groove and the second groove communicate with each other through a through hole; and the second lower pair bonding structure includes a first layer structure, a second layer structure, and a third layer structure that are sequentially stacked, the first layer structure is formed in the first groove through injection molding, the second layer structure is formed in the through hole through injection molding, and the third layer structure is formed in the second groove through injection molding. In this way, the second lower pair bonding structure and the recessed hole form an embedded structure, so that not only a binding force between the lower pair sliding groove and the first limiting structure can be improved, to improve position precision of the lower pair sliding groove, but also strength of the door panel and the lower pair sliding groove can be improved.

In some implementations, the first limiting structure is located inside the door panel; the first limiting structure includes a first specially shaped hole, a second specially shaped hole, and a third fastening groove, the first specially shaped hole and the second specially shaped hole form a stepped structure in a second direction, and the third fastening groove is close to the second specially shaped hole in a direction perpendicular to the first direction; and the second direction is a thickness direction of the door panel. In this way, the first specially shaped hole and the second specially shaped hole form two groups of staggered stepped structures. The two groups of staggered stepped structures are used for bonding, and features of the two groups of staggered stepped structures may impose a complete limitation in different axis directions, to improve position precision and strength of the lower pair sliding groove.

In some implementations, the lower pair sliding groove includes a third lower pair bonding structure, a third fastening base, and a third sliding groove base; the third lower pair bonding structure is continuously formed in the first specially shaped hole and the second specially shaped hole through injection molding, and the third lower pair bonding structure is a stepped structure; the third fastening base is formed in the third fastening groove through injection molding; and the third sliding groove base is connected to the third lower pair bonding structure and the third fastening base, and is injection-molded by a second height along the first surface in the second direction. The third lower pair bonding structure includes a first specially shaped structure and a second specially shaped structure; and the first specially shaped structure and the second specially shaped structure form a stepped structure in the direction perpendicular to the first direction. In this way, the lower pair sliding groove is embedded into the inside of the door panel by using the third lower pair bonding structure and the third fastening base, to improve a binding force between the lower pair sliding groove and the first limiting structure. The first limiting structure performs stepped bonding by using the first specially shaped hole and the second specially shaped hole, so that the lower pair sliding groove has a corresponding stepped bonding structure. In this way, not only stability of the lower pair sliding groove and the door panel can be improved, to improve strength of the door panel and the lower pair sliding groove, but also improve position precision of the lower pair sliding groove.

In some implementations, the door panel is integrally formed with the N higher pair sliding grooves. In this way, a thickness of the door panel can be reduced when the door panel assembly has higher strength, so that not only strength of the door panel and the higher pair sliding groove can be improved, but also a thickness of a rotary shaft mechanism including the door panel assembly can be reduced.

In some implementations, the M+N kinematic pair sliding grooves include M higher pair sliding grooves and N lower pair sliding grooves; and the M higher pair sliding grooves and the N lower pair sliding grooves are spaced apart from each other on the first surface in the first direction. In this way, different higher pair sliding grooves and different lower pair sliding grooves may be used to implement connection to different structural members in the rotary shaft mechanism.

In some implementations, the limiting structure includes a second limiting structure; in the first direction, M second limiting structures are spaced apart from each other, and are recessed from the first surface to an inside of the door panel; and positions of the M second limiting structures are opposite to positions of the M higher pair sliding grooves, and the M second limiting structures are configured to fasten the M higher pair sliding grooves. In this way, the second limiting structure may be used to fasten the higher pair sliding groove, to improve position precision and strength of the higher pair sliding groove.

In some implementations, the second limiting structure includes a third groove, and a first specially shaped groove and a second specially shaped groove that are located on two sides of a length direction of the third groove; the third groove, the first specially shaped groove, and the second specially shaped groove are recessed from the first surface to the inside of the door panel; and a length direction of the third groove is perpendicular to the first direction, and a length direction of the first specially shaped groove and a length direction of the second specially shaped groove are the same as the first direction. In this way, a binding force between the higher pair sliding groove and the second limiting structure can be improved, so that not only the higher pair sliding groove can be accurately positioned, to stably fasten the higher pair sliding groove, but also strength of the higher pair sliding groove can be improved.

In some implementations, the higher pair sliding groove includes a first higher pair bonding structure, a second higher pair bonding structure, a third higher pair bonding structure, and a fourth sliding groove base; the first higher pair bonding structure is embedded into the first specially shaped groove, the second higher pair bonding structure is embedded into the second specially shaped groove, the third higher pair bonding structure is embedded into the third groove, two ends of the first higher pair bonding structure in the first direction form a stepped structure, and two ends of the second higher pair bonding structure in the first direction form a stepped structure; the fourth sliding groove base is located on the third higher pair bonding structure, and is injection-molded by a third height relative to the first surface in a second direction; and the second direction is a thickness direction of the door panel. In this way, a binding force between the higher pair sliding groove and the second limiting structure can be improved, so that not only the higher pair sliding groove can be accurately positioned, to stably fasten the higher pair sliding groove, but also strength of the higher pair sliding groove can be improved.

In some implementations, the first specially shaped groove includes an upper groove, two communicating grooves, and two lower grooves; two sides of the upper groove in the first direction each communicate with one communicating groove, and each communicating groove communicates with one lower groove, so that two ends of the first specially shaped groove in the first direction form a stepped downward structure from the first surface to a second surface of the door panel; the first higher pair bonding structure includes an upper-layer structure, two support structures, and two lower-layer structures; two sides of the upper-layer structure in the first direction each are connected to one support structure, and each support structure is connected to one lower-layer structure, so that two ends of the first higher pair bonding structure in the first direction form a stepped downward structure from the first surface to the second surface; and the upper-layer structure is embedded into the upper groove, the support structure is embedded into the communicating groove, and the lower-layer structure is embedded into the lower groove. In this way, a stepped structure of the higher pair sliding groove and the second limiting structure of the door panel are distributed at two layers in a staggered manner, so that a complete limitation can be imposed in the first direction, to improve position precision and strength of the higher pair sliding groove.

In some implementations, the door panel is integrally formed with the N lower pair sliding grooves. In this way, not only a thickness of the door panel can be reduced in a case of higher strength, but also strength of the door panel and the lower pair sliding groove can be improved, and position precision of the lower pair sliding groove can be improved.

According to a second aspect, this application provides a manufacturing method for a door panel assembly, used to manufacture the door panel assembly according to the first aspect. The method includes: providing a first blank and a second blank; machining a door panel, N higher pair sliding grooves, and M first limiting structures on the first blank, where in a first direction, the N higher pair sliding grooves are spaced apart from each other in a first surface of the door panel, and the M first limiting structures are spaced apart from each other on the first surface and/or inside the door panel; and injection-molding the second blank in the M first limiting structures to form M lower pair sliding grooves, to obtain the door panel assembly. The first direction is a length direction of the door panel. In this way, strength of the door panel and strength of the higher pair sliding groove can be ensured, and position precision of the higher pair sliding groove can be improved. In this way, a thickness of the door panel and a wall thickness of the higher pair sliding groove can be further reduced, to reduce thickness space that is of a rotary shaft mechanism and that is occupied by the door panel assembly, and facilitate lightening and thinning of an electronic device including the rotary shaft mechanism. The lower pair sliding groove cooperates with a first limiting structure of the door panel through embedded injection molding, to meet precision of a kinematic mating surface and improve position precision and strength of the lower pair sliding groove.

According to a third aspect, this application provides a manufacturing method for a door panel assembly, used to manufacture the door panel assembly according to the first aspect. The method includes: providing a door panel member and M higher pair sliding grooves, where the door panel member includes a door panel, N lower pair sliding grooves, and M second limiting structures; and in a first direction, the N lower pair sliding groove are spaced apart from each other on a first surface of the door panel, the M second limiting structures are spaced apart from each other, and are recessed from the first surface to an inside of the door panel, and the first direction is a length direction of the door panel; and fastening the M higher pair sliding grooves to the door panel member, where the M higher pair sliding grooves and the M second limiting structures are in a one-to-one correspondence and form an embedded structure, to obtain the door panel assembly. In this way, strength of the door panel and strength of the lower pair sliding groove can be ensured, and position precision of the lower pair sliding groove can be improved. In this way, a thickness of the door panel and a wall thickness of the lower pair sliding groove can be further reduced, to reduce thickness space that is of a rotary shaft mechanism and that is occupied by the door panel assembly, and facilitate lightening and thinning of an electronic device including the rotary shaft mechanism. The higher pair sliding groove cooperates with the second limiting structure of the door panel by using an embedded structure, to meet precision of a kinematic mating surface and improve position precision and strength of the higher pair sliding groove.

According to a fourth aspect, this application provides a rotary shaft mechanism, including the door panel assembly according to the first aspect.

According to a fifth aspect, this application provides an electronic device, including the rotary shaft mechanism according to the fourth aspect.

It may be understood that both the rotary shaft mechanism and the electronic device provided in the foregoing aspects are all applied to the door panel assembly provided in the first aspect. Therefore, for beneficial effects that can be achieved by the rotary shaft mechanism and the electronic device, refer to beneficial effects in the door panel assembly provided in the first aspect. Details are not described herein again.

### BRIEF DESCRIPTION OF DRAWINGS

To describe technical solutions of this application more clearly, the following briefly describes accompanying drawings required in embodiments. Apparently, a person of ordinary skill in the art may still derive other accompanying drawings from these accompanying drawings without creative efforts.
FIG. 1 is a schematic diagram of a structure of an electronic device 100A according to an embodiment of this application;
FIG. 2A is a schematic diagram of a first structure of a screen 30 and a rotary shaft mechanism 40 according to an embodiment of this application;
FIG. 2B is a schematic diagram of a second structure of a screen 30 and a rotary shaft mechanism 40 according to an embodiment of this application;
FIG. 3 is a schematic diagram of a structure of a cross section A-A in FIG. 1;
FIG. 4 is a schematic diagram of a first structure of a door panel assembly 50 according to an embodiment of this application;
FIG. 5 is a schematic diagram of a second structure of a door panel assembly 50 according to an embodiment of this application;
FIG. 6 is a partially enlarged view of a region D in FIG. 5;
FIG. 7A is a schematic diagram of a third structure of a door panel assembly 50 according to an embodiment of this application;
FIG. 7B is a schematic diagram of a structure from another perspective of FIG. 7A;
FIG. 8 is a schematic exploded view of a structure of a region A in FIG. 4;
FIG. 9 is a schematic diagram of bonding in a region A according to an embodiment of this application;
FIG. 10 is a schematic diagram of a structure of a lower pair sliding groove 400 in a region A according to an embodiment of this application;
FIG. 11 is a schematic exploded view of a structure of a region B in FIG. 4;
FIG. 12 is a schematic diagram of bonding in a region B according to an embodiment of this application;
FIG. 13 is a schematic diagram of a structure of a lower pair sliding groove 400 in a region B according to an embodiment of this application;
FIG. 14 is a schematic diagram of a structure of a cross section B-B in (c) in FIG. 11;
FIG. 15 is a schematic exploded view of a structure of a region C in FIG. 4;
FIG. 16 is a schematic diagram of bonding in a region C according to an embodiment of this application;
FIG. 17 is a schematic diagram of a structure of a lower pair sliding groove 400 in a region C according to an embodiment of this application;
FIG. 18 is a schematic diagram of a fourth structure of a door panel assembly 50 according to an embodiment of this application;
FIG. 19 is a schematic diagram of a fifth structure of a door panel assembly 50 according to an embodiment of this application;
FIG. 20A is a schematic diagram of a fourth structure of a door panel assembly 50 according to an embodiment of this application;
FIG. 20B is a schematic diagram of a structure from another perspective of FIG. 20A;
FIG. 21 is a schematic exploded view of a structure of a region E in FIG. 20A;
FIG. 22 is a schematic diagram of a structure of a higher pair sliding groove 200 and a first specially shaped groove 502 according to an embodiment of this application;
FIG. 23 is a first flowchart of a manufacturing method for a door panel assembly according to an embodiment of this application;
FIG. 24 is a first process flowchart of a manufacturing method for a door panel assembly according to an embodiment of this application;
FIG. 25 is a second flowchart of a manufacturing method for a door panel assembly according to an embodiment of this application;
FIG. 26 is a second process flowchart of a manufacturing method for a door panel assembly according to an embodiment of this application; and
FIG. 27 is a third process flowchart of a manufacturing method for a door panel assembly according to an embodiment of this application.

### DESCRIPTION OF EMBODIMENTS

The following clearly describes the technical solutions in the embodiments of this application with reference to the accompanying drawings in the embodiments of this application. It is clear that the described embodiments are some but not all of the embodiments of this application. Other embodiments obtained by a person of ordinary skill in the art based on the embodiments of this application without creative efforts shall fall within the protection scope of this application.

The terms "first" and "second" below are merely intended for a purpose of description, and shall not be understood as an indication or implication of relative importance or implicit indication of a quantity of indicated technical features. Therefore, a feature defined by "first", "second", and the like may explicitly or implicitly include one or more such features. In the descriptions of this application, unless otherwise stated, "a plurality of" means two or more.

In addition, in this application, orientation terms such as "upper" and "lower" are defined relative to the orientations in which components in the accompanying drawings are schematically placed. It should be understood that these orientation terms are relative concepts, are used for relative description and clarification, and may be correspondingly changed based on changes in the orientations in which the components are placed in the accompanying drawings.

In the embodiments of this application, an electronic device includes but is not limited to a mobile phone, a foldable-screen mobile phone, a notebook computer, a tablet computer, a laptop computer, a personal digital assistant, or a wearable device. The following provides descriptions by using an example in which the electronic device is a foldable-screen mobile phone.

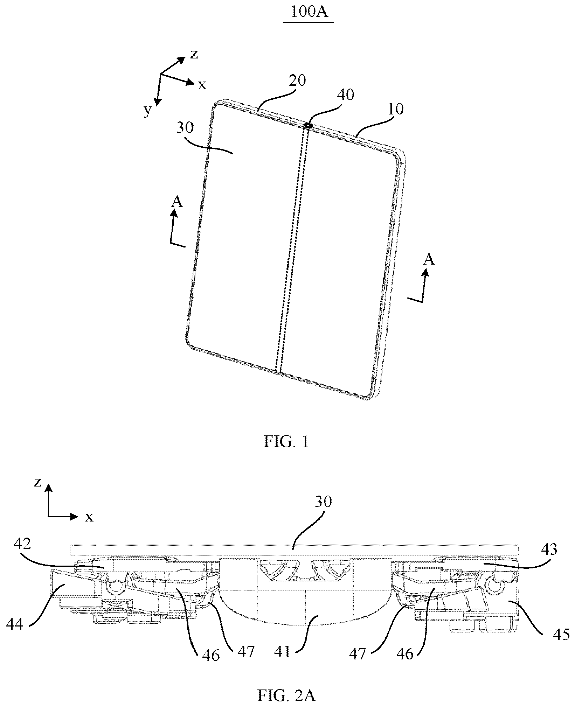

FIG. 1 is a schematic diagram of a structure of an electronic device 100A according to an embodiment of this application.

As shown in FIG. 1, the electronic device 100A may include a first body 10, a second body 20, a screen 30, and a rotary shaft mechanism 40. The first body 10 and the second body 20 are disposed on two sides of the rotary shaft mechanism 40 in an axis direction. The first body 10 and the second body 20 are separately connected to the rotary shaft mechanism 40, and may rotate through the rotary shaft mechanism 40, so that an included angle between the first body 10 and the second body 20 decreases until the electronic device is in a folded state, or an included angle between the first body 10 and the second body 20 increases until the electronic device is in an unfolded state.

The screen 30 covers the first body 10, the second body 20, and the rotary shaft mechanism 40, and is separately connected to the first body 10 and the second body 20. For example, the screen 30 may be a bendable flexible screen.

For ease of description of positions of components in the electronic device 100A, in this embodiment of this application, a three-dimensional coordinate system is established based on the electronic device 100. An x-axis direction is a width direction of the electronic device 100A, a y-axis direction is a length direction of the electronic device 100A, and a z-axis direction is a thickness direction of the electronic device 100A.

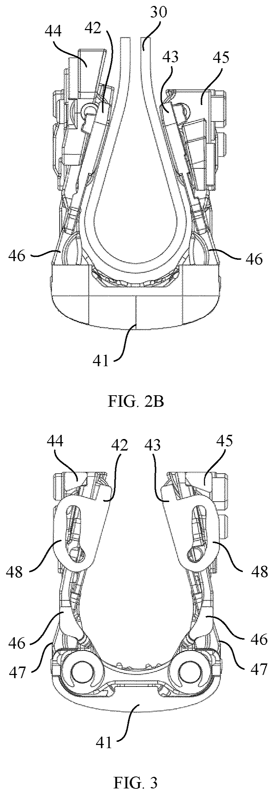

FIG. 2A is a schematic diagram of a first structure of a screen 30 and a rotary shaft mechanism 40 according to an embodiment of this application. FIG. 2B is a schematic diagram of a second structure of a screen 30 and a rotary shaft mechanism 40 according to an embodiment of this application.

As shown in FIG. 2A, the rotary shaft mechanism 40 is also in an unfolded state when the electronic device 100A is in the unfolded state. In the unfolded state, the first body 10 and the second body 20 are distributed on the two sides of the rotary shaft mechanism 40 in parallel, and the screen 30 is flatly placed on the rotary shaft mechanism 40 in the unfolded state.

As shown in FIG. 2B, the rotary shaft mechanism 40 is also in a folded state when the electronic device 100A is in the folded state. In the folded state, the first body 10 and the second body 20 are relatively distributed on the two sides of the rotary shaft mechanism 40, and the rotary shaft mechanism 40 presses the screen 30 into a water drop form.

FIG. 3 is a schematic diagram of a structure of a cross section A-A in FIG. 1. FIG. 3 shows only a structure of the rotary shaft mechanism 40, and other structures are not shown.

With reference to FIG. 2A, FIG. 2B, and FIG. 3, the rotary shaft mechanism 40 includes a base 41, a left door panel 42, a right door panel 43, a left connecting block 44, a right connecting block 45, a group of main swing arms 46, and a group of secondary swing arms 47. The left door panel 42 and the right door panel 43 are located on two sides of the base 41, the left door panel 42 is connected to the left connecting block 44, and the right door panel 43 is connected to the right connecting block 45. The left connecting block 44 is rotatably connected to one side of the base 41 by using one main swing arm 46 and one secondary swing arm 47, and the right connecting block 45 is rotatably connected to the other side of the base 41 by using one main swing arm 46 and one secondary swing arm 47. A rotary shaft may be disposed in the base 41, so that the main swing arm 46 and the secondary swing arm 47 can rotate around the base 41, to drive a corresponding connecting block to move. Further, the connecting block drives a corresponding door panel to rotate. At least one of the main swing arm 46 and the secondary swing arm 47 may alternatively be connected to a door panel (briefly referred to as a door panel below), to improve rotation precision.

The screen 30 covers the left door panel 42 and the right door panel 43, and is supported by using the door panel. The door panel may be fastened to the screen 30. The door panel may be folded or unfolded along with the rotary shaft mechanism 40, and may push the screen 30 to be folded or unfolded, to support the screen 30 in the unfolded state. The screen 30 is pressed into the water drop form, or the like in the folded state.

The door panel includes a plurality of kinematic pairs 48, configured to implement connection between structural members. For example, the kinematic pair 48 may implement connection between the door panel and the left connecting block 44, may further implement connection between the door panel and the main swing arm 46, and may further implement connection between the door panel and the secondary swing arm 47.

A molding manner of the door panel and the kinematic pair 48 may be usually an all-in-one (All in one, AIO) injection molding manner or a carbon fiber and embedded injection molding manner. However, in this molding manner, strength of the overall door panel and the kinematic pair tends to be weak, and thickness space of the rotary shaft mechanism 40 is occupied (in a z-axis direction). Further, thickness space of the electronic device occupied by the rotary shaft mechanism 40 is increased, and lightening and thinning of the electronic device cannot be achieved.

The molding manner of the door panel and the kinematic pair 48 may be usually a manner of performing connection through riveting. For example, a main body of the door panel is molded in an aluminum alloy computerized numerical control machining (Computerised Numerical Control Machine, CNC) manner, the kinematic pair 48 is molded in a metal powder injection molding (Metal Powder Injection Molding Technology, MIM) manner, and finally, the kinematic pair 48 and the main body of the door panel are riveted by using a screw. However, in this molding manner, a large quantity of screw parts are required, position precision of the kinematic pair is not easily ensured, and thickness space is also occupied. It can be learned that an existing door panel cannot meet a use requirement.

To resolve the foregoing technical problem, an embodiment of this application provides a door panel assembly 50, which has high strength, occupies no thickness space, has a precise position of a kinematic pair, and has other features, to meet a use requirement.

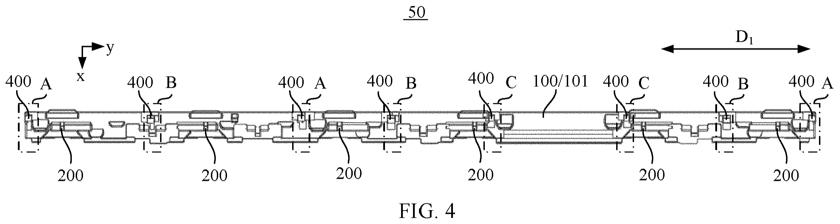

FIG. 4 is a schematic diagram of a first structure of a door panel assembly 50 according to an embodiment of this application.

As shown in FIG. 4, in some embodiments, the door panel assembly 50 may include a door panel 100, M limiting structures, and M+N kinematic pair sliding grooves. M is a positive integer, and N is a positive integer.

The door panel 100 includes a first surface 101. With reference to FIG. 2A, the first surface 101 is a surface away from a screen 30. For example, a length direction of the door panel 100 is defined as a first direction D₁, and the first direction D₁ is the same as a y-axis direction.

The M limiting structures are spaced apart from each other on the first surface 101 and/or inside the door panel 100 in the first direction. The M+N kinematic pair sliding grooves are spaced apart from each other on the first surface 101 in the first direction, positions of the M kinematic pair sliding grooves are opposite to positions of the M limiting structures, the M kinematic pair sliding grooves are fastened to the corresponding limiting structures, and the N kinematic pair sliding grooves are integrally formed with the door panel 100.

In this way, according to the door panel assembly 50 provided in this embodiment of this application, the M kinematic pair sliding grooves are fastened by using the M limiting structures on the door panel 100, and the N kinematic pair sliding grooves are integrally formed with the door panel 100, to not only improve strength of the door panel 100 and each kinematic pair sliding groove, but also improve position precision of each kinematic pair sliding groove. The limiting structure is located on the first surface 101 and/or inside the door panel 100, and does not occupy thickness space of the door panel 100, and therefore does not affect thickness space of a rotary shaft mechanism 40, to implement lightening and thinning of the electronic device 100A and meet a use requirement.

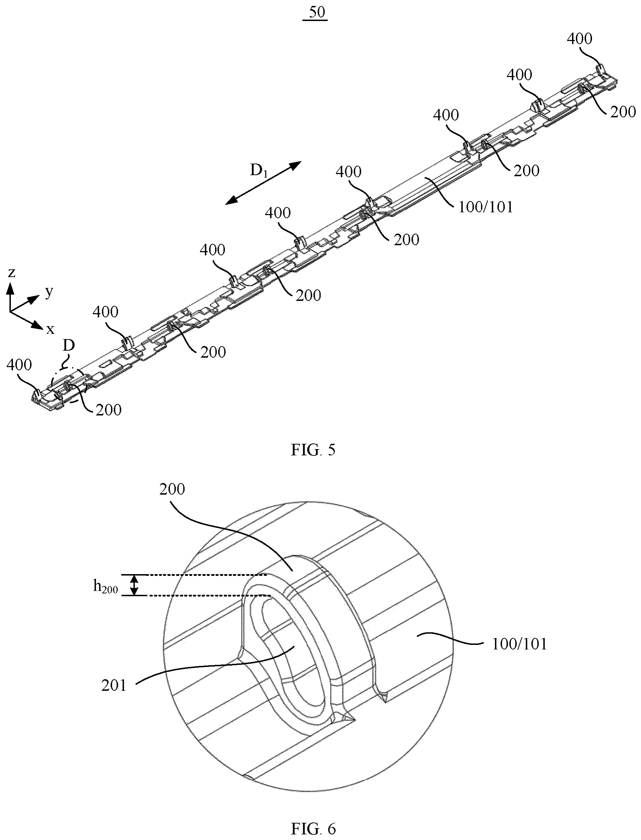

FIG. 5 is a schematic diagram of a second structure of a door panel assembly 50 according to an embodiment of this application.

With reference to FIG. 4 and FIG. 5, in some embodiments, the M+N kinematic pair sliding grooves may include M higher pair sliding grooves 200 and N lower pair sliding grooves 400, or the N higher pair sliding grooves 200 and the M lower pair sliding grooves 400. In this way, different higher pair sliding grooves 200 and different lower pair sliding grooves 400 may be used to implement connection to different structural members in the rotary shaft mechanism 40.

For example, the M+N kinematic pair sliding grooves include the N higher pair sliding grooves 200 and the M lower pair sliding grooves 400. The N higher pair sliding grooves 200 and the M lower pair sliding grooves 400 are spaced apart from each other on the first surface 101 in the first direction. For example, the N higher pair sliding grooves 200 are adjacent to the M lower pair sliding grooves 400, and there is a distance between the N higher pair sliding grooves 200 and the M lower pair sliding grooves 400. For example, N may be 6, and M may be 8.

FIG. 6 is a partially enlarged view of a region D in FIG. 5.

As shown in FIG. 6, in some embodiments, the N higher pair sliding grooves 200 may have a same structure. The higher pair sliding groove 200 may include a sliding groove 201, and the N higher pair sliding grooves 200 are configured to be connected to a main swing arm 46 and/or a secondary swing arm 47 in the rotary shaft mechanism 40 by using corresponding sliding grooves 201. The M lower pair sliding grooves 400 are configured to be connected to a connecting block.

In this way, a distance and positions of two adjacent higher pair sliding grooves 200 are not specifically limited, but may correspond to a position of the main swing arm 46 or the secondary swing arm 47, to implement precise connection between the door panel 100 and the main swing arm 46 and/or the secondary swing arm 47. Similarly, a distance and positions of two adjacent lower pair sliding grooves 400 are not specifically limited, but may correspond to a position of the connecting block, to implement precise connection between the door panel 100 and the connecting block.

In some embodiments, both the door panel 100 and the N higher pair sliding grooves 200 may be made of a material with high strength, for example, a metal material or a polymer material, and the door panel 100 and the N higher pair sliding grooves 200 may be integrally formed. For example, both the door panel 100 and the N higher pair sliding grooves 200 are made of the metal material such as stainless steel or titanium alloy. In this way, a high-strength material may be used to reduce a thickness of the door panel 100 and a wall thickness h₂₀₀ of the higher pair sliding groove 200, and the wall thickness h₂₀₀ of the higher pair sliding groove 200 may be reduced to be less than 0.35 mm, to reduce thickness space.

The lower pair sliding groove 400 may be made of a hard plastic material. For example, the plastic material may include a polycarbonate (Polycarbonate, PC) plastic material, and the like.

In this embodiment of this application, a high-precision feature such as a shape of the door panel 100 and an end face of the higher pair sliding groove 200 may be obtained by performing CNC machining on a metal blank, to ensure that a position of each higher pair sliding groove 200 relative to the door panel 100 is accurate. In addition, the high-strength material may be used to reduce the thickness of the door panel 100 in a case of higher strength, so that not only strength of the door panel 100 and the higher pair sliding groove 200 can be improved, but also a thickness of the rotary shaft mechanism can be reduced.

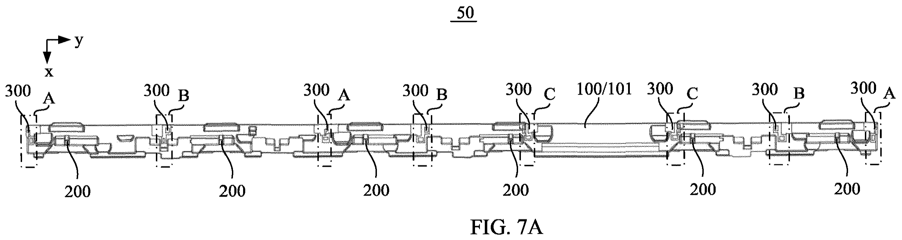

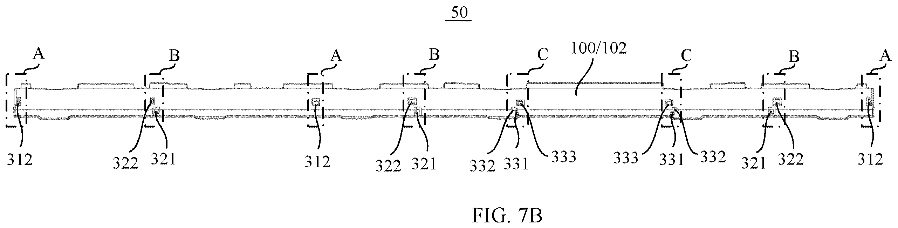

FIG. 7A is a schematic diagram of a third structure of a door panel assembly 50 according to an embodiment of this application. FIG. 7B is a schematic diagram of a structure from another perspective of FIG. 7A. FIG. 7A does not show a structure of the lower pair sliding groove 400.

As shown in FIG. 7A and FIG. 7B, in some embodiments, the limiting structure may include a first limiting structure 300. M first limiting structures 300 are spaced apart from each other on the first surface 101 and/or inside the door panel 100 in the first direction. For example, the M first limiting structures 300 may be integrally formed with the door panel 100.

The M first limiting structures 300 are configured to fasten the M lower pair sliding grooves 400. Positions of the M first limiting structures 300 are in a one-to-one correspondence with positions of the M lower pair sliding grooves 400, the lower pair sliding groove 400 may be made of the plastic material, and the M lower pair sliding grooves 400 are formed on the corresponding first limiting structures 300 through injection molding.

In this way, for the lower pair sliding groove 400, a bonding structure may be generated on the corresponding first limiting structure 300 through injection molding. Based on the bonding structure, binding strength between the lower pair sliding groove 400 and the first limiting structure 300 may be improved, so that strength of the lower pair sliding groove 400 and the door panel 100 is improved.

With reference to FIG. 4, FIG. 7A, and FIG. 7B, based on positions of different lower pair sliding grooves 400 on the door panel 100, limited by a thickness of the door panel 100 and another structural member of the door panel 100, positions and structures of different first limiting structures 300 are different, and therefore, structures of the lower pair sliding grooves 400 are also different.

For example, the first limiting structure 300 may include three structures, and the three structures are distributed at different positions on the door panel 100 such as a region A, a region B, and a region C. If there are three regions A, three first limiting structures 300 in the regions A are a same structure, and correspondingly, three lower pair sliding grooves 400 in the regions A are of a same structure. If there are three regions B, three first limiting structures 300 in the regions B are a same structure, and correspondingly, three lower pair sliding grooves 400 in the regions B are of a same structure. If there are two regions C, two first limiting structures 300 in the regions C are a same structure, and correspondingly, two lower pair sliding grooves 400 in the regions C are of a same structure.

The following provides descriptions by using the region A, the region B, the region C, and structures of a first limiting structure 300 and a lower pair sliding groove 400 in one group in each region as an example.

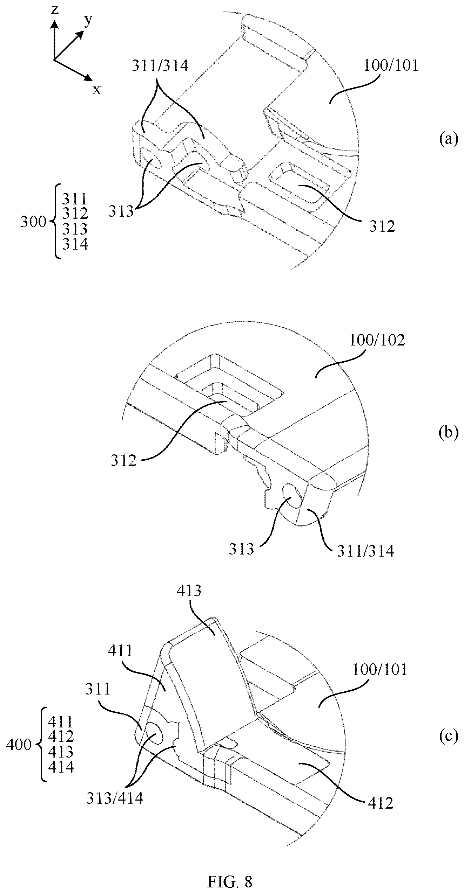

FIG. 8 is a schematic exploded view of a structure of a region A in FIG. 4. (a) in FIG. 8 shows a structure in which the first limiting structure 300 is located on the first surface 101 of the door panel 100. (b) in FIG. 8 shows a structure in which the first limiting structure 300 is located on a second surface 102 of the door panel 100. The first surface 101 and the second surface 102 are opposite surfaces. With reference to FIG. 2A, the second surface 102 is a surface close to the screen 30. (c) in FIG. 8 is a schematic diagram in which the first limiting structure 300 and the lower pair sliding groove 400 are combined.

As shown in (a) in FIG. 8 and (b) in FIG. 8, in some embodiments, the first limiting structure 300 may be located on the first surface 101 of the door panel 100.

The first limiting structure 300 may include a base 311 and a first fastening groove 312. The first fastening groove 312 is close to the base 311 in a direction (y-axis direction) perpendicular to the first direction. The direction perpendicular to the first direction is the same as an x-axis direction.

The base 311 is located on the first surface 101 and protrudes by a specific height along a z-axis direction. The first fastening groove 312 includes an upper groove (not shown in the figure) that is recessed by the first depth from the first surface 101 to an inside of the door panel 100, and a lower groove (not shown in the figure) that is recessed by the second depth from the second surface 102 to the inside of the door panel 100, and the upper groove communicates with the lower groove. A sum of the first depth and the second depth is less than the thickness of the door panel 100.

The base 311 may include at least one through hole 313. An axis direction of the through hole 313 is the same as the first direction. In other words, the axis direction of the through hole 313 is the same as the y-axis direction. The base 311 may include at least two substrates 314 forming a stepped structure in the first direction, and each substrate 314 includes a corresponding through hole 313.

As shown in (c) in FIG. 8, plastic is injection-molded on the first limiting structure 300, to form the lower pair sliding groove 400 in the region A.

In this way, plastic may be distributed in the through hole 313 and two stepped substrates 314 in a bonding manner, to improve a binding force between the lower pair sliding groove 400 and the first limiting structure 300. In this way, not only the lower pair sliding groove 400 can be accurately positioned, to stably fasten the lower pair sliding groove 400, but also strength of the lower pair sliding groove 400 can be improved.

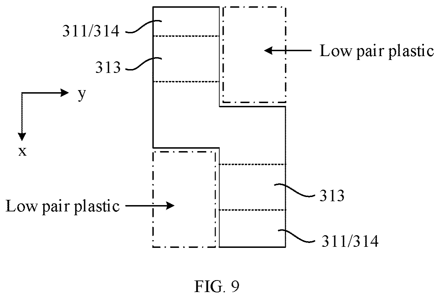

FIG. 9 is a schematic diagram of bonding in a region A according to an embodiment of this application.

As shown in (a) in FIG. 8 and FIG. 9, in some embodiments, the two substrates 314 are distributed in a staggered manner in a stepped form in the first direction (the y-axis direction), so that the two substrates 314 form two staggered regions. Lower pair plastic is injection-molded in the two staggered regions and the first fastening groove 312 by using an injection molding process, the entire base 311 is covered through bonding, and plastic is filled into the through hole 313 of each substrate 314.

In this way, in this bonding manner, a stepped structure and a through hole structure are used for bonding. A stepped bonding structure feature may be used to perform bonding and limitation in the x/y-axis direction, and a through hole bonding structure feature may be used to perform bonding and limitation in the z-axis direction. The stepped structure may implement a two-layer meat thickness (lower pair plastic-base 311) bonding feature. Compared with a common three-layer meat thickness bonding feature, in this embodiment of this application, one layer of meat thickness may be reduced in the y-axis direction. For example, y-direction space can be saved by more than 0.25 mm, to avoid insufficient y-direction space.

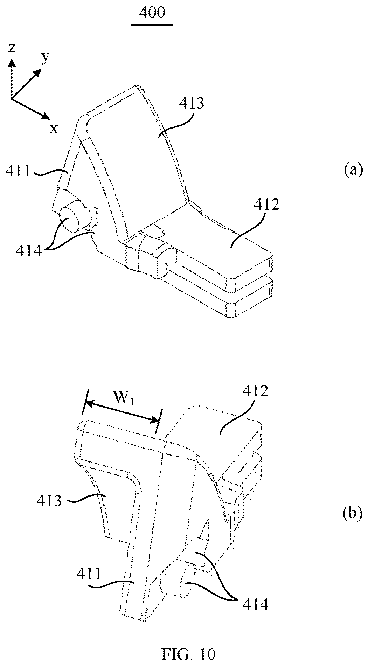

FIG. 10 is a schematic diagram of a structure of a lower pair sliding groove 400 in a region A according to an embodiment of this application. (a) in FIG. 10 and (b) in FIG. 10 may show structures of a lower pair sliding groove 400 from different perspectives.

As shown in (a) in FIG. 8, (a) in FIG. 10, and (b) in FIG. 10, in some embodiments, the lower pair sliding groove 400 may include a first lower pair bonding structure 411, a first fastening base 412, and a first sliding groove base 413.

The lower pair plastic is injection-molded into the base 311 and the at least one through hole 313 through injection molding and bonding, to form the first lower pair bonding structure 411. The first lower pair bonding structure 411 includes at least one fastening post 414 formed in the at least one through hole 313, to improve strength and position precision of the lower pair sliding groove 400.

The lower pair plastic is injection-molded on a top of a side surface of the first lower pair bonding structure 411, and is injection-molded by a first width W1 in the first direction (the y-axis direction), to form the first sliding groove base 413. The first sliding groove base 413 is configured to be connected to a connecting block of the rotary shaft mechanism.

The lower pair plastic is injection-molded into the first fastening groove 312, to form the first fastening base 412. The first fastening base 412 is connected to the first lower pair bonding structure 411 and the first sliding groove base 413, to improve strength of the lower pair sliding groove 400.

For example, an upper surface of the first fastening base 412 may be flush with or lower than the first surface 101, and a lower surface of the first fastening base 412 may be flush with or lower than the second surface 102. In this way, the lower pair sliding groove 400 may be prevented from affecting another structural member of the door panel 100.

The lower pair sliding groove 400 in the region A is embedded into the door panel 100 by using the first fastening base 412, and the first lower pair bonding structure 411 and the base 311 are bound, to improve a binding force between the lower pair sliding groove 400 and the first limiting structure 300. Based on the stepped structure, the first limiting structure 300 is distributed at two layers of plastic in a staggered manner, so that the lower pair sliding groove 400 has a stepped bonding structure. Based on the through hole structure, the lower pair sliding groove 400 has a hole bonding structure. In this way, not only stability of the lower pair sliding groove 400 and the door panel 100 can be improved, to improve strength of the door panel 100 and the lower pair sliding groove 400, but also improve position precision of the lower pair sliding groove 400.

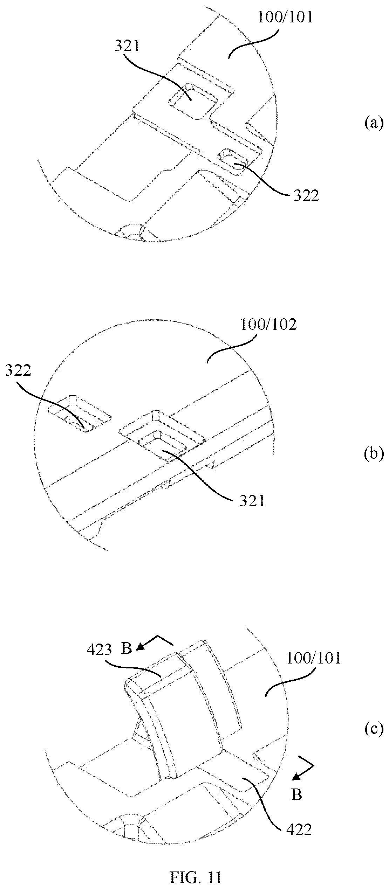

FIG. 11 is a schematic exploded view of a structure of a region B in FIG. 4. (a) in FIG. 11 shows a structure in which the first limiting structure 300 is located on the first surface 101 of the door panel 100. (b) in FIG. 11 shows a structure in which the first limiting structure 300 is located on the second surface 102 of the door panel 100. (c) in FIG. 11 is a schematic diagram in which the first limiting structure 300 and the lower pair sliding groove 400 are combined.

As shown in (a) in FIG. 11 and (b) in FIG. 11, in some embodiments, the first limiting structure 300 is located inside the door panel 100.

The first limiting structure 300 may include a recessed hole 321 and a second fastening groove 322. The recessed hole 321 is formed by being recessed from the first surface 101 to the inside of the door panel 100 and being recessed from the second surface 102 to the inside of the door panel 100. The second fastening groove 322 is close to the recessed hole 321 in a direction perpendicular to the first direction. A structure of the second fastening groove 322 is the same as a structure of the first fastening groove 312. Details are not described herein again.

As shown in (c) in FIG. 11, plastic is injection-molded on the first limiting structure 300, to form the lower pair sliding groove 400 in the region B.

In this way, plastic may be distributed in the recessed hole 321 and the second fastening groove 322 in a bonding manner, to improve a binding force between the lower pair sliding groove 400 and the first limiting structure 300. In this way, not only the lower pair sliding groove 400 can be accurately positioned, to stably fasten the lower pair sliding groove 400, but also strength of the lower pair sliding groove 400 can be improved.

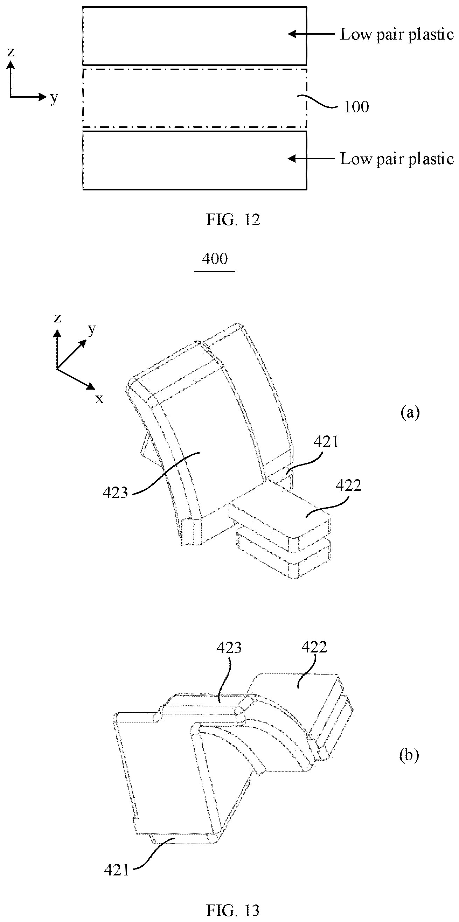

FIG. 12 is a schematic diagram of bonding in a region B according to an embodiment of this application.

As shown in (a) in FIG. 11 and FIG. 12, in some embodiments, a three-layer bonding structure is used in the region B, and the three-layer structure is distributed in the z-axis direction, and is respectively a lower pair plastic-door panel 100-lower pair plastic. The three-layer structure is used to implement bonding and limitation of the lower pair plastic in the x/y/z-axis direction, to improve stability, strength, and position precision of the lower pair sliding groove 400.

FIG. 13 is a schematic diagram of a structure of a lower pair sliding groove 400 in a region B according to an embodiment of this application. (a) in FIG. 13 and (b) in FIG. 13 may show structures of a lower pair sliding groove 400 from different perspectives.

As shown in (a) in FIG. 11, (a) in FIG. 13, and (b) in FIG. 13, in some embodiments, the lower pair sliding groove 400 may include a second lower pair bonding structure 421, a second fastening base 422, and a second sliding groove base 423.

The lower pair plastic is injection-molded into the recessed hole 321 through injection molding and bonding, to form the second lower pair bonding structure 421. The lower pair plastic is injection-molded into the second fastening groove 322, to form the second fastening base 422. The second lower pair bonding structure 421 and the second fastening base 422 are disposed in a staggered manner in the y-axis direction, and a staggering region is formed between the second lower pair bonding structure 421 and the second fastening base 422. The lower pair plastic is injection-molded into the staggering region, and is injection-molded by a first height along the first surface 101 in a second direction, to form the second sliding groove base 423. The second sliding groove base 423 is configured to be connected to a connecting block of the rotary shaft mechanism. The first height meets a connection requirement between the second sliding groove base 423 and the connecting block.

The second sliding groove base 423 is connected to the second lower pair bonding structure 421 and the second fastening base 422, to improve strength of the lower pair sliding groove 400. The second direction is a thickness direction of the door panel 100. In other words, the second direction is the z-axis direction.

The lower pair sliding groove 400 in the region B is embedded into the door panel 100 by using the second lower pair bonding structure 421 and the second fastening base 422, to improve a binding force between the lower pair sliding groove 400 and the first limiting structure 300. In the first limiting structure 300, three-layer bonding is performed by using the recessed hole 321, so that the lower pair sliding groove 400 has a corresponding bonding structure. In this way, not only stability of the lower pair sliding groove 400 and the door panel 100 can be improved, to improve strength of the door panel 100 and the lower pair sliding groove 400, but also improve position precision of the lower pair sliding groove 400.

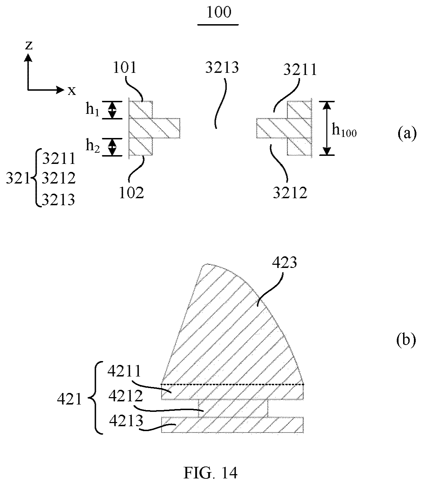

FIG. 14 is a schematic diagram of a structure of a cross section B-B in (c) in FIG. 11.

As shown in (a) in FIG. 14, in some embodiments, the recessed hole 321 may include a first groove 3211 and a second groove 3212. The first groove 3211 is recessed by a first depth h₁ from the first surface 101 to the inside of the door panel 100, the second groove 3212 is recessed by a second depth h₂ from the second surface 102 of the door panel 100 to the inside, and the first groove 3211 and the second groove 3212 communicate with each other through a through hole 3213. A sum of the first depth h₁ and the second depth h₂ is less than the thickness h₁₀₀ of the door panel 100.

A width of the through hole 3213 is less than a width of the first groove 3211 or a width of the second groove 3212. The width of the first groove 3211 and the width of the second groove 3212 may be the same or different.

As shown in (b) in FIG. 14, in some embodiments, the second lower pair bonding structure 421 may include a first layer structure 4211, a second layer structure 4212, and a third layer structure 4213 that are sequentially stacked. The second sliding groove base 423 is formed above the first layer structure 4211 through injection molding.

The lower pair plastic is sequentially injection-molded into the first groove 3211, the through hole 3213, and the second groove 3212 through injection molding and bonding. In this way, the first layer structure 4211 may be formed in the first groove 3211, the second layer structure 4212 may be formed in the through hole 3213, and the third layer structure 4213 may be formed in the second groove 3212.

For example, the upper surface of the first fastening base 412 may be flush with or lower than the first surface 101, and the lower surface of the first fastening base 412 may be flush with or lower than the second surface 102. In this way, the lower pair sliding groove 400 may be prevented from affecting another structural member of the door panel 100.

In this way, the second lower pair bonding structure 421 and the recessed hole 321 form an embedded structure, so that not only a binding force between the lower pair sliding groove 400 and the first limiting structure 300 can be improved, to improve position precision of the lower pair sliding groove 400, but also strength of the door panel 100 and the lower pair sliding groove 400 can be improved.

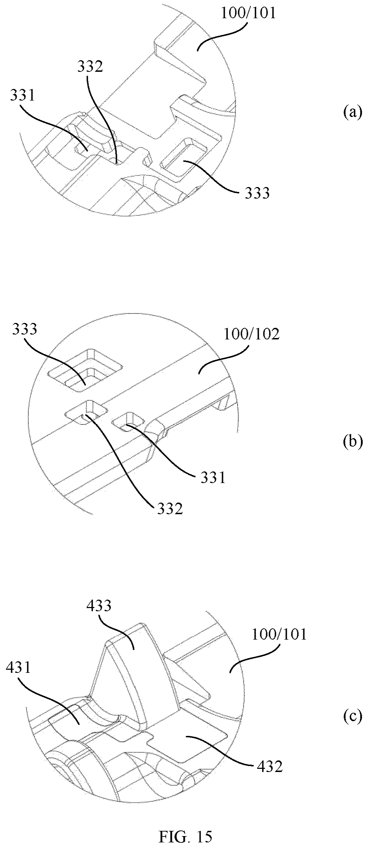

FIG. 15 is a schematic exploded view of a structure of a region C in FIG. 4. (a) in FIG. 15 shows a structure in which the first limiting structure 300 is located on the first surface 101 of the door panel 100. (b) in FIG. 15 shows a structure in which the first limiting structure 300 is located on the second surface 102 of the door panel 100. (c) in FIG. 15 is a schematic diagram in which the first limiting structure 300 and the lower pair sliding groove 400 are combined.

As shown in (a) in FIG. 15 and (b) in FIG. 15, in some embodiments, the first limiting structure 300 is located inside the door panel 100.

The first limiting structure 300 includes a first specially shaped hole 331, a second specially shaped hole 332, and a third fastening groove 333. The first specially shaped hole 331 and the second specially shaped hole 332 are disposed in a staggered manner in a stepped structure in the second direction (the z-axis direction), the first specially shaped hole 331 may be in a stepped structure, and the second specially shaped hole 332 may be in a stepped structure.

The third fastening groove 333 is close to the second specially shaped hole 332 in the direction perpendicular to the first direction. It should be noted that a structure of the third fastening groove 333, a structure of the second fastening groove 322, and a structure of the first fastening groove 312 may all be a structure of the recessed hole 321. Details are not described herein again.

As shown in (c) in FIG. 15, plastic is injection-molded on the first limiting structure 300, to form the lower pair sliding groove 400 in the region C.

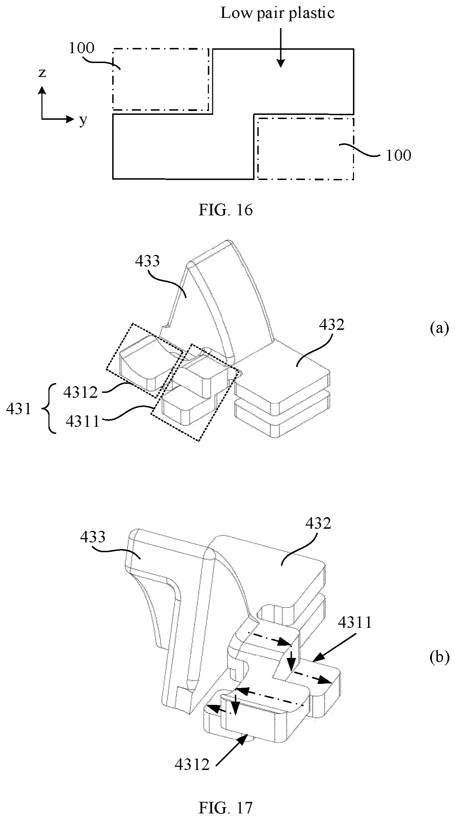

FIG. 16 is a schematic diagram of bonding in a region C according to an embodiment of this application.

As shown in (a) in FIG. 15 and FIG. 16, in some embodiments, the first specially shaped hole 331 and the second specially shaped hole 332 form two groups of staggered stepped structures. The two groups of staggered stepped structures are used for bonding, and features of the two groups of staggered stepped structures may impose a complete limitation in the x/y/z direction. In this bonding manner, two-layer meat thickness bonding (lower pair plastic-door panel) may be implemented. Compared with a common three-layer meat thickness bonding feature, in this embodiment of this application, one layer of meat thickness may be reduced in the z-axis direction. For example, z-direction space can be saved by 0.25 mm, occupied z-direction space of the door panel 100 may be reduced, and further, a thickness of the door panel assembly 50 may be reduced.

FIG. 17 is a schematic diagram of a structure of a lower pair sliding groove 400 in a region C according to an embodiment of this application. (a) in FIG. 17 and (b) in FIG. 17 may show structures of a lower pair sliding groove 400 from different perspectives.

As shown in (a) in FIG. 15, (a) in FIG. 17, and (b) in FIG. 17, in some embodiments, the lower pair sliding groove 400 may include a third lower pair bonding structure 431, a third fastening base 432, and a third sliding groove base 433.

The lower pair plastic is injection-molded into the first specially shaped hole 331 and the second specially shaped hole 332 through injection molding and bonding, to form the third lower pair bonding structure 431. The third lower pair bonding structure 431 is a stepped structure.

The lower pair plastic is injection-molded into the third fastening groove 333, to form the third fastening base 432. The third lower pair bonding structure 431 and the third fastening base 432 are disposed in a staggered manner in the y-axis direction, and a staggering region is formed between the third lower pair bonding structure 431 and the third fastening base 432. The lower pair plastic is injection-molded into the staggering region, and is injection-molded by a second height along the first surface 101 in the second direction (the z-axis direction), to form the third sliding groove base 433. The third sliding groove base 433 is configured to be connected to a connecting block of the rotary shaft mechanism. The second height meets a connection requirement between the third sliding groove base 433 and the connecting block.

The third sliding groove base 433 is connected to the third lower pair bonding structure 431 and the third fastening base 432, to improve strength of the lower pair sliding groove 400.

In some embodiments, the third lower pair bonding structure 431 may include a first specially shaped structure 4311 and a second specially shaped structure 4312. The first specially shaped structure 4311 is formed by injection-molding the lower pair plastic in the first specially shaped hole 331, and the second specially shaped structure 4312 is formed by injection-molding the lower pair plastic into the second specially shaped hole 332. In this way, the first specially shaped structure 4311 is a stepped structure in the x-axis direction, the second specially shaped structure 4312 is a stepped structure in the x-axis direction, and a stepped structure in the y-axis direction is formed between the first specially shaped structure 4311 and the second specially shaped structure 4312.

The lower pair sliding groove 400 in the region C is embedded into the door panel 100 by using the third lower pair bonding structure 431 and the third fastening base 432, to improve a binding force between the lower pair sliding groove 400 and the first limiting structure 300. The first limiting structure 300 performs stepped bonding by using the first specially shaped hole 331 and the second specially shaped hole 332, so that the lower pair sliding groove 400 has a corresponding stepped bonding structure. In this way, not only stability of the lower pair sliding groove 400 and the door panel 100 can be improved, to improve strength of the door panel 100 and the lower pair sliding groove 400, but also improve position precision of the lower pair sliding groove 400.

The door panel assembly 50 provided in this embodiment of this application includes the door panel 100, the N higher pair sliding grooves 200, the M first limiting structures 300, and the M lower pair sliding grooves 400. The N higher pair sliding grooves 200 and the door panel 100 may be made of a high-strength material and integrally formed. In this way, not only the thickness of the door panel 100 can be reduced in a case of higher strength, but also strength of the door panel 100 and the N higher pair sliding grooves 200 can be improved, and position precision of the N higher pair sliding grooves 200 can be improved. The M lower pair sliding grooves 400 are formed on the M first limiting structures 300 through injection molding, and based on different first limiting structures 300, the M lower pair sliding groove 400 are different bonding structures. Based on the bonding structure, binding strength between the M lower pair sliding grooves 400 and the M first limiting structures 300 can be improved, so that strength of the M lower pair sliding grooves 400 and the door panel 100 can be improved, and position precision of the M lower pair sliding grooves 400 can be improved.

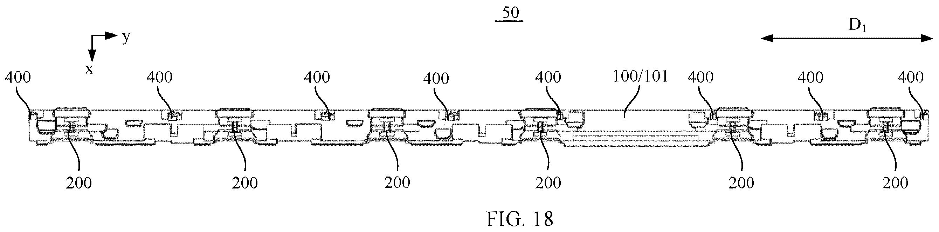

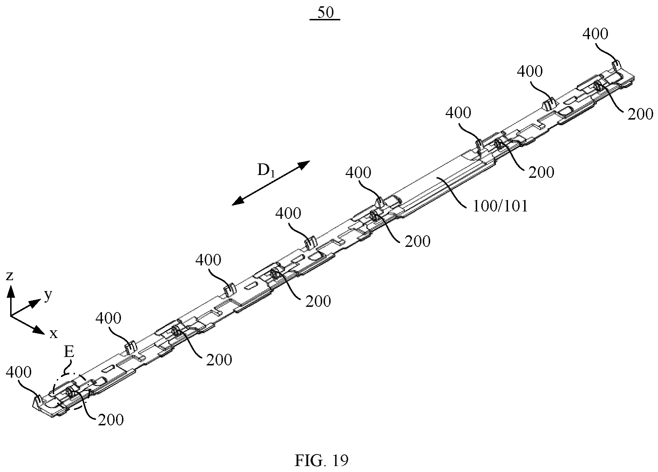

FIG. 18 is a schematic diagram of a fourth structure of a door panel assembly 50 according to an embodiment of this application. FIG. 19 is a schematic diagram of a fifth structure of a door panel assembly 50 according to an embodiment of this application.

As shown in FIG. 18 and FIG. 19, in some embodiments, in the door panel assembly 50 provided in this embodiment of this application, for example, the M+N kinematic pair sliding grooves include the M higher pair sliding grooves 200 and the N lower pair sliding grooves 400. The M higher pair sliding grooves 200 and the N lower pair sliding grooves 400 are spaced apart from each other on the first surface 101 in the first direction. The M higher pair sliding grooves 200 may not be integrally formed with the door panel 100. The M higher pair sliding grooves 200 may be integrally formed with the door panel 100 in a form of metal inserts, and the N lower pair sliding grooves 400 may be integrally formed with the door panel 100. For example, N may be 8, and M may be 6.

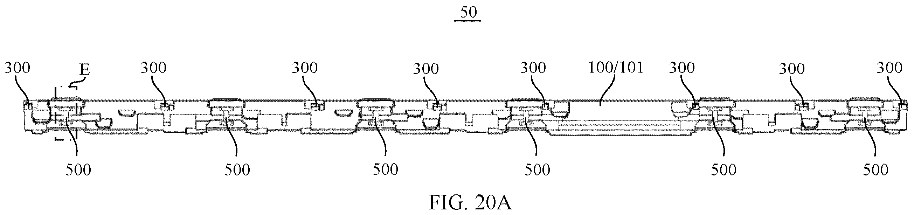

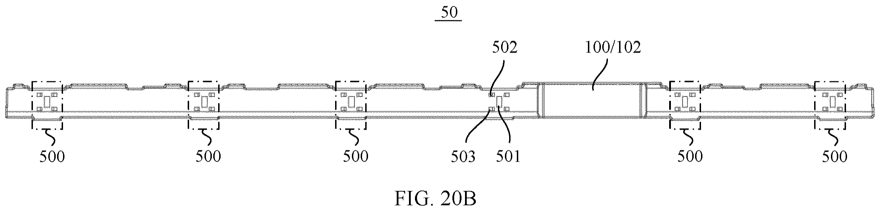

FIG. 20A is a schematic diagram of a fourth structure of a door panel assembly 50 according to an embodiment of this application. FIG. 20B is a schematic diagram of a structure from another perspective of FIG. 20A. FIG. 20A does not show a structure of the higher pair sliding groove 200.

As shown in FIG. 20A and FIG. 20B, in some embodiments, the limiting structure may include a second limiting structure 500. In the first direction, the M second limiting structures 500 are spaced apart from each other, and are recessed from the first surface 101 to the inside of the door panel 100. For example, the M second limiting structures 500 may be integrally formed with the door panel 100.

A quantity of the M second limiting structures 500 is the same as a quantity of the M higher pair sliding grooves 200, positions of the M second limiting structures 500 are opposite to positions of the M higher pair sliding grooves 200, and the M second limiting structures 500 are configured to fasten the M higher pair sliding grooves 200 in the form of metal inserts. For example, a material of the higher pair sliding groove 200 may be a metal material such as stainless steel or titanium alloy, and the higher pair sliding groove 200 may be pre-molded into a metal insert.

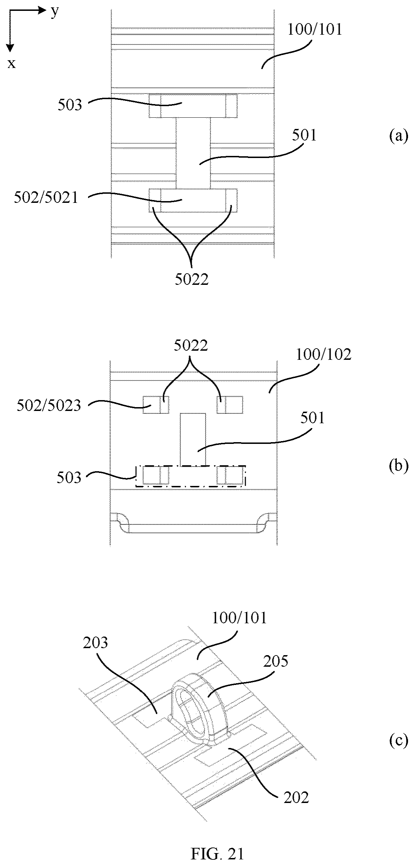

FIG. 21 is a schematic exploded view of a structure of a region E in FIG. 20A. (a) in FIG. 21 shows a structure in which the second limiting structure 500 is located on the first surface 101 of the door panel 100. (b) in FIG. 21 shows a structure in which the second limiting structure 500 is located on the second surface 102 of the door panel 100. (c) in FIG. 21 is a schematic diagram in which the second limiting structure 500 and the higher pair sliding groove 200 are combined.

As shown in (a) in FIG. 21 and (b) in FIG. 21, in some embodiments, the second limiting structure 500 may include a third groove 501, and a first specially shaped groove 502 and a second specially shaped groove 503 that are located on two sides of a length direction of the third groove 501.

The length direction of the third groove 501 is perpendicular to the first direction (the y-axis direction), and the length direction of the third groove 501 is a width direction of the door panel 100 (the x-axis direction). A length direction of the first specially shaped groove 502 is the same as the first direction, and the length direction of the first specially shaped groove 502 is a length direction of the door panel 100. A length direction of the second specially shaped groove 503 is the same as the first direction, and the length direction of the second specially shaped groove 503 is the length direction of the door panel 100. The first specially shaped groove 502 and the second specially shaped groove 503 may be parallel.

The third groove 501, the first specially shaped groove 502, and the second specially shaped groove 503 are recessed from the first surface 101 to the inside of the door panel 100. The third groove 501 may penetrate through the first surface 101 and the second surface 102 of the door panel 100, and the first specially shaped groove 502 and the second specially shaped groove 503 may also include a part that penetrates through the first surface 101 and the second surface 102.

As shown in (c) in FIG. 21, the second limiting structure 500 is integrally formed with the higher pair sliding groove 200, to obtain the door panel assembly 50 shown in FIG. 18 and FIG. 19.

In this way, the higher pair sliding groove 200 may have a bonding structure adapted to the second limiting structure 500. In this way, a binding force between the higher pair sliding groove 200 and the second limiting structure 500 can be improved, so that not only the higher pair sliding groove 200 can be accurately positioned, to stably fasten the higher pair sliding groove 200, but also strength of the higher pair sliding groove 200 can be improved.

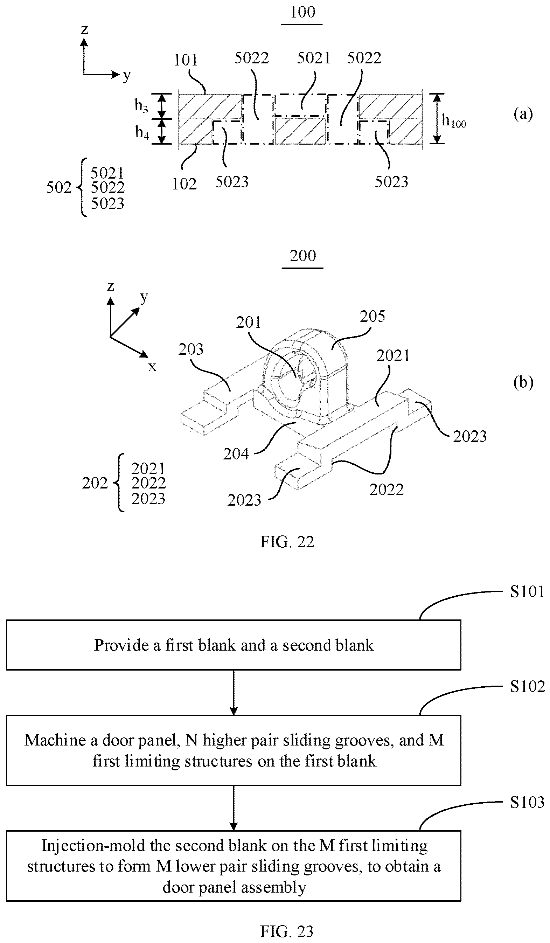

FIG. 22 is a schematic diagram of a structure of a higher pair sliding groove 200 and a first specially shaped groove 502 according to an embodiment of this application. (a) in FIG. 22 is a cross-sectional view of a first specially shaped groove 502 in the y-axis direction.

As shown in FIG. 21 and (a) in FIG. 22, in some embodiments, a structure of the first specially shaped groove 502 and a structure of the second specially shaped groove 503 are the same. The following provides descriptions by using the structure of the first specially shaped groove 502 as an example.

The first specially shaped groove 502 may include an upper groove 5021, a communicating groove 5022, and a lower groove 5023. It should be noted that dashed lines in (a) in FIG. 22 show only examples of a region of the upper groove 5021, a region of the communicating groove 5022, and a region of the lower groove 5023, and does not constitute a limitation on corresponding structures.

The upper groove 5021 is recessed by a third depth h₃ from the first surface 101 to the inside of the door panel 100, the lower groove 5023 is recessed by a fourth depth h₄ from the second surface 102 of the door panel 100 to the inside, the communicating groove 5022 penetrates through the first surface 101 and the second surface 102, and the upper groove 5021 and the lower groove 5023 communicate with each other through the communicating groove 5022. A sum of the third depth h₃ and the fourth depth h₄ is equal to the thickness h₁₀₀ of the door panel 100.

Two communicating grooves 5022 are included, and two lower grooves 5023 are included. Two sides of the upper groove 5021 in the y-axis direction each communicate with one communicating groove 5022, each communicating groove 5022 communicates with one lower groove 5023, and the lower groove 5023 is away from the upper groove 5021 along the y-axis direction relative to the corresponding communicating groove 5022. In this way, two ends of the first specially shaped groove 502 in the y-axis direction may form a stepped downward structure from the first surface 101 to the second surface 102.

As shown in FIG. 21 and (b) in FIG. 22, in some embodiments, the higher pair sliding groove 200 may include a first higher pair bonding structure 202, a second higher pair bonding structure 203, a third higher pair bonding structure 204, and a fourth sliding groove base 205.

A length direction of the third higher pair bonding structure 204 is the same as the x-axis direction, the first higher pair bonding structure 202 and the second higher pair bonding structure 203 are respectively located at two ends of the third higher pair bonding structure 204 in the x-axis direction, and a length direction of the first higher pair bonding structure 202 and a length direction of the second higher pair bonding structure 203 are the same as the y-axis direction.

The fourth sliding groove base 205 is located between the first higher pair bonding structure 202 and the second higher pair bonding structure 203, and is located on a surface of the third higher pair bonding structure 204 in the z-axis direction. The fourth sliding groove base 205 is injection-molded by a third height relative to the first surface 101 along the z-axis direction. The fourth sliding groove base 205 may further include a sliding groove 201, and is connected to the main swing arm 46 and/or the secondary swing arm 47 in the rotary shaft mechanism 40 by using the sliding groove 201. The third height meets a connection requirement between the fourth sliding groove base 205 and the main swing arm 46 and/or the secondary swing arm 47 in the rotary shaft mechanism 40.

The third higher pair bonding structure 204 is configured to be embedded into the third groove 501, the first higher pair bonding structure 202 is configured to be imbedded into the first specially shaped groove 502, and the second higher pair bonding structure 203 is configured to be embedded into the second specially shaped groove 503.

A structure of the first higher pair bonding structure 202 is the same as a structure of the second higher pair bonding structure 203. The following provides descriptions by using the structure of the first higher pair bonding structure 202 as an example.

The first higher pair bonding structure 202 may include an upper-layer structure 2021, a support structure 2022, and a lower-layer structure 2023. A length direction of the upper-layer structure 2021 is the same as the y-axis direction, a length direction of the support structure 2022 is the same as the z-axis direction, and a length direction of the lower-layer structure 2023 is the same as the y-axis direction. The upper-layer structure 2021 is connected to the lower-layer structure 2023 by using the support structure 2022.

Two support structures 2022 are included, and two lower-layer structures 2023 are included. Two sides of the upper-layer structure 2021 in the y-axis direction each are connected to one support structure 2022, each support structure 2022 is connected to one lower-layer structure 2023, and the lower-layer structure 2023 is away from the upper-layer structure 2021 along the y-axis direction relative to the corresponding support structure 2022. In this way, two ends of the first higher pair bonding structure 202 in the y-axis direction may form a stepped downward structure from the first surface 101 to the second surface 102.

When the second limiting structure 500 is bound to the higher pair sliding groove 200, the third higher pair bonding structure 204 is embedded into the third groove 501, the upper-layer structure 2021 of the first higher pair bonding structure 202 is embedded into the upper groove 5021 of the first specially shaped groove 502, the support structure 2022 is embedded into the communicating groove 5022, and the lower-layer structure 2023 is embedded into the lower groove 5023. Similarly, the second higher pair bonding structure 203 is embedded into the second specially shaped groove 503. For example, an outer surface of the upper-layer structure 2021 may be flush with or lower than the first surface 101, and an outer surface of the lower-layer structure 2023 may be flush with or lower than the second surface 102. In this way, the higher pair sliding groove 200 may be prevented from affecting another structural member of the door panel 100.

Two ends of the first higher pair bonding structure 202 of the higher pair sliding groove 200 in the first direction form a stepped structure. In this way, the stepped structure and the second limiting structure 500 of the door panel 100 are distributed at two layers in a staggered manner, so that a complete limitation can be imposed in the y-axis direction, to improve position precision and strength of the higher pair sliding groove 200.

The door panel assembly 50 provided in this embodiment of this application includes the door panel 100, the M higher pair sliding grooves 200, the N lower pair sliding grooves 400, and the M second limiting structures 500. The N lower pair sliding grooves 400 and the door panel 100 may be made of a material with high strength, for example, a metal material or a polymer material, or may be integrally formed. In this way, not only the thickness of the door panel 100 can be reduced in a case of higher strength, but also strength of the door panel 100 and the N lower pair sliding grooves 400 can be improved, and position precision of the N lower pair sliding grooves 400 can be improved. The M higher pair sliding groove 200 is correspondingly embedded into and integrally formed with the M second limiting structures 500, and based on a structure of the second limiting structure 500, the higher pair sliding groove 200 has a corresponding stepped bonding structure. Based on the stepped bonding structure, binding strength between the M lower pair sliding grooves 200 and the M second limiting structures 500 can be improved, so that strength of the M higher pair sliding grooves 200 and the door panel 100 can be improved, and position precision of the M higher pair sliding grooves 200 can be improved.

In some embodiments, the door panel assembly 50 may include both the first limiting structure 300 and the second limiting structure 500. In this way, the door panel 100 and the higher pair sliding groove 200 are not integrally formed, and the door panel 100 and the lower pair sliding groove 400 are not integrally formed. The first limiting structure 300 and the second limiting structure 500 are machined on the door panel 100, the lower pair sliding groove 400 is formed on the first limiting structure 300 through injection-molding, and the higher pair sliding groove 200 is embedded into and integrally formed with the second limiting structure 500. For specific implementations, structural characteristic, and effects, refer to content of the foregoing embodiments. Details are not described herein again.

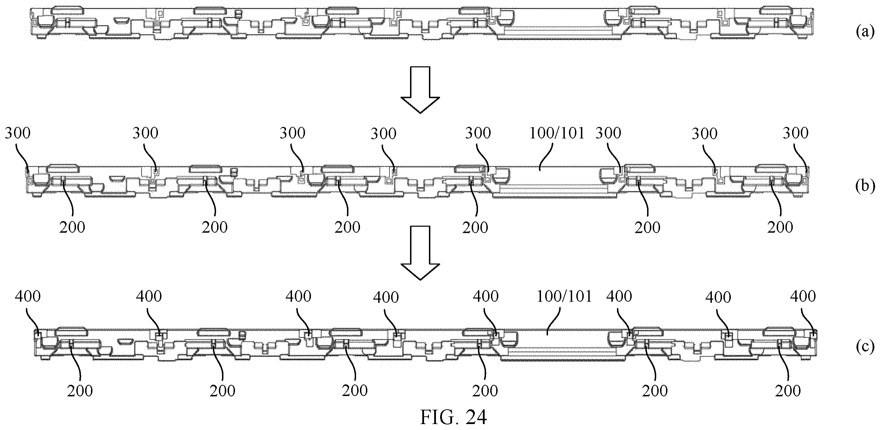

FIG. 23 is a first flowchart of a manufacturing method for a door panel assembly according to an embodiment of this application. FIG. 24 is a first process flowchart of a manufacturing method for a door panel assembly according to an embodiment of this application.

As shown in FIG. 23, in some embodiments, the manufacturing method for a door panel assembly is used to manufacture the door panel assembly 50 provided in any one of the foregoing embodiments corresponding to FIG. 4 to FIG. 17. The method may include step S101 to step S103.

Step S101: Provide a first blank and a second blank.

The first blank may be a blank with high strength, for example, a metal blank or a polymer material blank, and the second blank may be a plastic material.

As shown in (a) in FIG. 24, a raw material metal blank is provided, and a door panel 100 and N higher pair sliding grooves 200 are integrally formed in an MIM manner, to obtain the first blank. The first blank includes an initial structure of the door panel 100 and an initial structure of the N higher pair sliding grooves 200. The metal blank may be made of a metal material such as stainless steel or titanium alloy.

Step S102: Machine the door panel 100, the N higher pair sliding grooves 200, and M first limiting structures 300 on the first blank.

As shown in (b) in FIG. 24, based on a CNC machine technology, a high-precision feature such as a shape of the door panel 100, an end surface of the M first limiting structures 300, and an end surface of the N higher pair sliding grooves 200 are obtained by performing CNC machining on the first blank. For a structure of the higher pair sliding groove 200, refer to the structure shown in FIG. 6. Details are not described herein again.

In the first direction, the N higher pair sliding grooves 200 are spaced apart from each other on the first surface 101 of the door panel 100, and the M first limiting structures 300 are spaced apart from each other on the first surface 101 and/or inside the door panel 100. The first direction is a length direction of the door panel. In other words, the first direction is a y-axis direction.

The first limiting structure 300 may include three structures. For specific structure forms, refer to content shown in FIG. 9, FIG. 11, and FIG. 15. Details are not described herein again.

Step S103: Injection-mold the second blank in the M first limiting structures 300 to form M lower pair sliding grooves 400, to obtain the door panel assembly 50.

As shown in (c) in FIG. 24, plastic is injection-molded in different first limiting structures 300, and bonding is performed on the first limiting structure 300 to obtain a lower pair sliding groove 400, so that different lower pair sliding groove 400 have different bonding structures.

It should be noted that content such as structural characteristics and effects of the door panel assembly 50 are briefly disclosed in this embodiment of this application. For corresponding content, refer to content of the foregoing embodiments corresponding to FIG. 4 to FIG. 17. Details are not described herein again.

According to the manufacturing method for a door panel assembly 50 provided in this embodiment of this application, two materials are integrally formed by using an all-in-one design and through secondary molding, to implement an all-in-one solution of the door panel 100. A main body of the door panel 100 of the door panel assembly 50 and the N higher pair sliding grooves 200 are molded by using a same material. In this way, strength of the door panel 100 and strength of the N higher pair sliding grooves 200 can be ensured, and position precision of the N higher pair sliding grooves 200 can be improved. In this way, a thickness of the door panel 100 and wall thicknesses of the N higher pair sliding grooves 200 can be further reduced, to reduce thickness space that is of a rotary shaft mechanism and that is occupied by the door panel assembly 50, and facilitate lightening and thinning of an electronic device including the rotary shaft mechanism. The M lower pair sliding grooves 400 cooperate with the M first limiting structures 300 on the door panel 100 through embedded injection molding, to meet precision of a kinematic mating surface and improve position precision of the M lower pair sliding grooves 400. The M lower pair sliding grooves 400 are of different stepped bonding structures. In the stepped bonding structure, a plurality of layers of plastic are distributed in a staggered manner, so that a complete limitation in a x/y/z-axis direction can be implemented, and strength of the M lower pair sliding grooves 400 is improved.

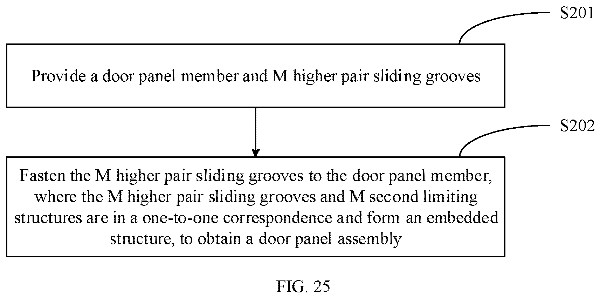

FIG. 25 is a second flowchart of a manufacturing method for a door panel assembly according to an embodiment of this application.

As shown in FIG. 25, in some embodiments, the manufacturing method for a door panel assembly is used to manufacture the door panel assembly 50 provided in any one of the foregoing embodiments corresponding to FIG. 18 to FIG. 22. The method may include step S201 and step S202.

Step S201: Provide a door panel member and M higher pair sliding grooves.

The door panel member includes a door panel 100, N lower pair sliding grooves 400, and M second limiting structures 500. In the first direction, the N lower pair sliding grooves 400 are spaced apart from each other on a first surface 101 of the door panel 100, and the M second limiting structures 500 are spaced apart from each other, and are recessed from the first surface 101 to an inside of the door panel 100. The first direction is a length direction of the door panel 100.

In the door panel member, the door panel 100 and the N lower pair sliding grooves 400 may be integrally formed by using a metal material such as stainless steel or titanium alloy; or the door panel 100 and the N lower pair sliding grooves 400 may be integrally formed in an amorphous molding manner.

M higher pair sliding grooves 200 may be made of a metal material such as stainless steel or titanium alloy and molded in an MIM molding manner.

Step S202: Fasten the M higher pair sliding grooves to the door panel member, where the M higher pair sliding grooves and the M second limiting structures are in a one-to-one correspondence and form an embedded structure, to obtain the door panel assembly.

There are two manners of integrating the M higher pair sliding grooves 200 with the door panel member: embedding the M higher pair sliding grooves 200 into the door panel member, or embedding the door panel member into the M higher pair sliding grooves 200.

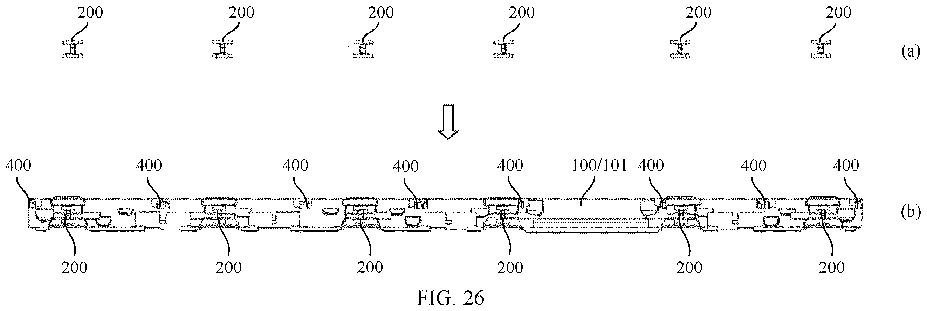

FIG. 26 is a second process flowchart of a manufacturing method for a door panel assembly according to an embodiment of this application.

As shown in (a) in FIG. 26, in some embodiments, the M higher pair sliding grooves 200 are provided when a manner in which the door panel member is imbedded into the M higher pair sliding grooves 200 is used. Positions of the M higher pair sliding groove 200 may be arranged at a preset spacing, and a structure of the higher pair sliding groove 200 may be the structure shown in (b) in FIG. 22. The higher pair sliding groove 200 may be made of a metal material such as stainless steel or titanium alloy and molded in an MIM molding manner.

As shown in (b) in FIG. 26, in some embodiments, the door panel member is molded on the M higher pair sliding grooves 200 in the amorphous molding manner, so that the door panel member is embedded into the M higher pair sliding grooves 200, to obtain the door panel assembly 50.

Herein, the door panel 100 in the door panel member may be made of a metal material such as stainless steel or titanium alloy, and the N lower pair sliding grooves 400 may be made of a plastic material. In the amorphous molding manner, different materials may be integrally formed.

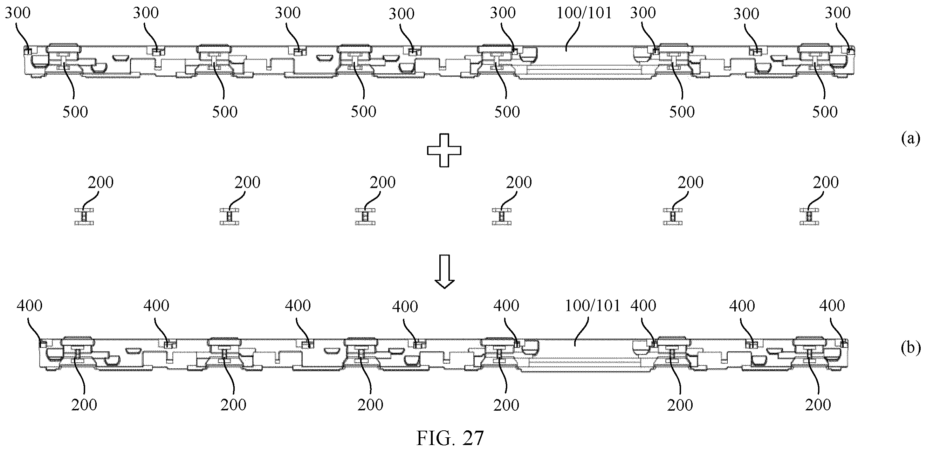

FIG. 27 is a third process flowchart of a manufacturing method for a door panel assembly according to an embodiment of this application.

As shown in (a) in FIG. 27, in some embodiments, the door panel member and the M higher pair sliding grooves 200 are provided when a manner in which the M higher pair sliding grooves 200 are embedded into the door panel member is used.

The door panel 100 in the door panel member and the N lower pair sliding grooves 400 may be made of a metal material such as stainless steel or titanium alloy and integrally formed in an MIM molding manner. The door panel member further includes the M second limiting structures 500, and the M second limiting structures 500 are located on the door panel 100.

The M higher pair sliding grooves 200 may be made of a metal material such as stainless steel or titanium alloy and molded in an MIM molding manner. In this way, two types of metal inserts, namely, inserts of the door panel member and the higher pair sliding groove 200 may be obtained.

As shown in (b) in FIG. 27, in some embodiments, the M higher pair sliding grooves 200 are embedded into the M second limiting structures 500 of the door panel member to form an embedded structure, to obtain the door panel assembly 50.

It should be noted that content such as structural characteristics and effects of the door panel assembly 50 are briefly disclosed in this embodiment of this application. For corresponding content, refer to content of the foregoing embodiments corresponding to FIG. 18 to FIG. 22. Details are not described herein again.

According to the manufacturing method for a door panel assembly 50 provided in this embodiment of this application, two materials are integrally formed by using an all-in-one design and through secondary molding, to implement an all-in-one solution of the door panel 100. A main body of the door panel 100 of the door panel assembly 50 and the N lower pair sliding grooves 400 are integrally formed by using a same material or different materials. In this way, strength of the door panel 100 and strength of the N lower pair sliding grooves 400 can be ensured, and position precision of the N lower pair sliding grooves 400 can be improved. In this way, a thickness of the door panel 100 and wall thicknesses of the N lower pair sliding grooves 400 can be further reduced, to reduce thickness space that is of a rotary shaft mechanism and that is occupied by the door panel assembly 50, and facilitate lightening and thinning of an electronic device including the rotary shaft mechanism. The M higher pair sliding grooves 200 cooperate with the M second limiting structures 500 on the door panel 100 by using an embedded structure, to meet precision of a kinematic mating surface and improve position precision of the M higher pair sliding grooves 200. The M higher pair sliding grooves 200 are of a stepped bonding structure. Based on the stepped bonding structure, a plurality of layers of plastic are distributed in a staggered manner, so that a complete limitation in a x/y/z-axis direction can be implemented, and strength of the M higher pair sliding grooves 200 is improved.

It should be noted that a person skilled in the art may easily think of another implementation solution of this application after considering the specification and practicing the application disclosed herein. This application is intended to cover any variations, functions, or adaptive changes of this application. These variations, functions, or adaptive changes comply with general principles of this application, and include common knowledge or a commonly used technical means in the art that is not disclosed in this application. This specification and the embodiments are merely considered as examples, and the actual scope of this application is pointed out by the following claims.

It should be understood that this application is not limited to the precise structures described above and shown in the accompanying drawings, and various modifications and changes may be made without departing from the scope thereof. The scope of this application is limited only by the appended claims.

## Claims

1. A door panel assembly, comprising:
a door panel (100), comprising a first surface (101), wherein a length direction of the door panel (100) is a first direction;
M limiting structures, wherein the M limiting structures are spaced apart from each other on the first surface (101) and/or inside the door panel (100) in the first direction; and
M+N kinematic pair sliding grooves, wherein the M+N kinematic pair sliding grooves are spaced apart from each other on the first surface (101) in the first direction, positions of the M kinematic pair sliding grooves are opposite to positions of the M limiting structures, the M kinematic pair sliding grooves are fastened to the corresponding limiting structures, the N kinematic pair sliding grooves are integrally formed with the door panel (100), M is a positive integer, and N is a positive integer.

2. The door panel assembly according to claim 1, wherein
the M+N kinematic pair sliding grooves comprise N higher pair sliding grooves (200) and M lower pair sliding grooves (400); and
the N higher pair sliding grooves (200) and the M lower pair sliding grooves (400) are spaced apart from each other on the first surface (101) in the first direction.

3. The door panel assembly according to claim 2, wherein
the limiting structure comprises a first limiting structure (300);
M first limiting structures (300) are spaced apart from each other on the first surface (101) and/or inside the door panel (100) in the first direction; and
positions of the M first limiting structures (300) are opposite to positions of the M lower pair sliding grooves (400), and the M lower pair sliding grooves (400) are formed on the corresponding first limiting structures (300) through injection molding.

4. The door panel assembly according to claim 3, wherein
the first limiting structure (300) is located on the first surface (101); and
the first limiting structure (300) comprises a base (311) and a first fastening groove (312), the first fastening groove (312) is close to the base (311) in a direction perpendicular to the first direction, the base (311) comprises at least one through hole (313), and an axis direction of the through hole (313) is the same as the first direction.

5. The door panel assembly according to claim 4, wherein
the base (311) comprises at least two substrates (314) forming a stepped structure in the first direction; and
the substrate (314) comprises the through hole (313).

6. The door panel assembly according to claim 5, wherein
the lower pair sliding groove (400) comprises a first lower pair bonding structure (411), a first fastening base (412), and a first sliding groove base (413);
the first lower pair bonding structure (411) is formed on the base (311) and in the at least one through hole (313) through injection molding, and the first lower pair bonding structure (411) comprises at least one fastening post (414) formed in the at least one through hole (313);
the first sliding groove base (413) is formed on a top of a side surface of the first lower pair bonding structure (411) through injection molding, and is injection-molded by a first width in the first direction; and
the first fastening base (412) is formed in the first fastening groove (312) through injection molding, and is connected to the first lower pair bonding structure (411) and the first sliding groove base (413).

7. The door panel assembly according to claim 3, wherein
the first limiting structure (300) is located inside the door panel (100); and
the first limiting structure (300) comprises a recessed hole (321) and a second fastening groove (322), and the second fastening groove (322) is close to the recessed hole (321) in a direction perpendicular to the first direction.

8. The door panel assembly according to claim 7, wherein
the lower pair sliding groove (400) comprises a second lower pair bonding structure (421), a second fastening base (422), and a second sliding groove base (423);
the second lower pair bonding structure (421) is formed in the recessed hole (321) through injection molding;
the second fastening base (422) is formed in the second fastening groove (322) through injection molding;
the second sliding groove base (423) is connected to the second lower pair bonding structure (421) and the second fastening base (422), and is injection-molded by a first height along the first surface (101) in a second direction; and
the second direction is a thickness direction of the door panel (100).

9. The door panel assembly according to claim 8, wherein
the recessed hole (321) comprises a first groove (3211) and a second groove (3212), the first groove (3211) is recessed by a first depth from the first surface (101) to an inside of the door panel (100), the second groove (3212) is recessed by a second depth from a second surface (102) of the door panel (100) to the inside, and the first groove (3211) and the second groove (3212) communicate with each other through a through hole (3213); and
the second lower pair bonding structure (421) comprises a first layer structure (4211), a second layer structure (4212), and a third layer structure (4213) that are sequentially stacked, the first layer structure (4211) is formed in the first groove (3211) through injection molding, the second layer structure (4212) is formed in the through hole (3213) through injection molding, and the third layer structure (4213) is formed in the second groove (3212) through injection molding.

10. The door panel assembly according to claim 3, wherein
the first limiting structure (300) is located inside the door panel (100);
the first limiting structure (300) comprises a first specially shaped hole (331), a second specially shaped hole (332), and a third fastening groove (333), the first specially shaped hole (331) and the second specially shaped hole (332) form a stepped structure in a second direction, and the third fastening groove (333) is close to the second specially shaped hole (332) in a direction perpendicular to the first direction; and
the second direction is a thickness direction of the door panel (100).

11. The door panel assembly according to claim 10, wherein
the lower pair sliding groove (400) comprises a third lower pair bonding structure (431), a third fastening base (432), and a third sliding groove base (433);
the third lower pair bonding structure (431) is continuously formed in the first specially shaped hole (331) and the second specially shaped hole (332) through injection molding, and the third lower pair bonding structure (431) is a stepped structure;
the third fastening base (432) is formed in the third fastening groove (333) through injection molding; and
the third sliding groove base (433) is connected to the third lower pair bonding structure (431) and the third fastening base (432), and is injection-molded by a second height along the first surface (101) in the second direction.

12. The door panel assembly according to claim 11, wherein
the third lower pair bonding structure (431) comprises a first specially shaped structure (4311) and a second specially shaped structure (4312); and
the first specially shaped structure (4311) and the second specially shaped structure (4312) form a stepped structure in the direction perpendicular to the first direction.

13. The door panel assembly according to any one of claims 2-12, wherein
the door panel (100) is integrally formed with the N higher pair sliding grooves (200).

14. The door panel assembly according to claim 1, wherein
the M+N kinematic pair sliding grooves comprise M higher pair sliding grooves (200) and N lower pair sliding grooves (400); and
the M higher pair sliding grooves (200) and the N lower pair sliding grooves (400) are spaced apart from each other on the first surface (101) in the first direction.

15. The door panel assembly according to claim 14, wherein
the limiting structure comprises a second limiting structure (500);
in the first direction, M second limiting structures (500) are spaced apart from each other, and are recessed from the first surface (101) to an inside of the door panel (100); and
positions of the M second limiting structures (500) are opposite to positions of the M higher pair sliding grooves (200), and the M second limiting structures (500) are configured to fasten the M higher pair sliding grooves (200).

16. The door panel assembly according to claim 15, wherein
the second limiting structure (500) comprises a third groove (501), and a first specially shaped groove (502) and a second specially shaped groove (503) that are located on two sides of a length direction of the third groove (501);
the third groove (501), the first specially shaped groove (502), and the second specially shaped groove (503) are recessed from the first surface (101) to the inside of the door panel (100); and
a length direction of the third groove (501) is perpendicular to the first direction, and a length direction of the first specially shaped groove (502) and a length direction of the second specially shaped groove (503) are the same as the first direction.

17. The door panel assembly according to claim 16, wherein
the higher pair sliding groove (200) comprises a first higher pair bonding structure (202), a second higher pair bonding structure (203), a third higher pair bonding structure (204), and a fourth sliding groove base (205);
the first higher pair bonding structure (202) is embedded into the first specially shaped groove (502), the second higher pair bonding structure (203) is embedded into the second specially shaped groove (503), the third higher pair bonding structure (204) is embedded into the third groove (501), two ends of the first higher pair bonding structure (202) in the first direction form a stepped structure, and two ends of the second higher pair bonding structure (203) in the first direction form a stepped structure;
the fourth sliding groove base (205) is located on the third higher pair bonding structure (204), and is injection-molded by a third height relative to the first surface (101) in a second direction; and
the second direction is a thickness direction of the door panel (100).

18. The door panel assembly according to claim 17, wherein
the first specially shaped groove (502) comprises an upper groove (5021), two communicating grooves (5022), and two lower grooves (5023);
two sides of the upper groove (5021) in the first direction each communicate with one communicating groove (5022), and each communicating groove (5022) communicates with one lower groove (5023), so that two ends of the first specially shaped groove (502) in the first direction form a stepped downward structure from the first surface (101) to a second surface (102) of the door panel;
the first higher pair bonding structure (202) comprises an upper-layer structure (2021), two support structures (2022), and two lower-layer structures (2023);
two sides of the upper-layer structure (2021) in the first direction each are connected to one support structure (2022), and each support structure (2022) is connected to one lower-layer structure (2023), so that two ends of the first higher pair bonding structure (202) in the first direction form a stepped downward structure from the first surface (101) to the second surface (102); and
the upper-layer structure (2021) is embedded into the upper groove (5021), the support structure (2022) is embedded into the communicating groove (5022), and the lower-layer structure (2023) is embedded into the lower groove (5023).

19. The door panel assembly according to any one of claims 14-18, wherein
the door panel (100) is integrally formed with the N lower pair sliding grooves (400).

20. A manufacturing method for a door panel assembly, used to manufacture the door panel assembly according to any one of claims 1-13, wherein the method comprises:
providing a first blank and a second blank;
machining a door panel, N higher pair sliding grooves, and M first limiting structures on the first blank, wherein in a first direction, the N higher pair sliding grooves are spaced apart from each other on a first surface of the door panel, and the M first limiting structures are spaced apart from each other on the first surface and/or inside the door panel; and
injection-molding the second blank in the M first limiting structures to form M lower pair sliding grooves, to obtain the door panel assembly, wherein
the first direction is a length direction of the door panel.

21. A manufacturing method for a door panel assembly, used to manufacture the door panel assembly according to any one of claims 14-19, wherein the method comprises:
providing a door panel member and M higher pair sliding grooves, wherein the door panel member comprises a door panel, N lower pair sliding grooves, and M second limiting structures; and in a first direction, the N lower pair sliding groove are spaced apart from each other on a first surface of the door panel, the M second limiting structures are spaced apart from each other, and are recessed from the first surface to an inside of the door panel, and the first direction is a length direction of the door panel; and
fastening the M higher pair sliding grooves to the door panel member, wherein the M higher pair sliding grooves and the M second limiting structures are in a one-to-one correspondence and form an embedded structure, to obtain the door panel assembly.

22. A rotary shaft mechanism, comprising the door panel assembly according to any one of claims 1-19.

23. An electronic device, comprising the rotary shaft mechanism according to claim 22.
